# EUROPEAN PATENT APPLICATION

(11) **EP 4 770 379 A1**
(43) Date of publication of application: **01.07.2026**
(21) Application number: 25210520.0
(22) Date of filing: 22.10.2025
(51) Int. Cl.: H10K 59/131, H10K 59/82

(54) **DISPLAY DEVICE**

(30) Priority: 30.12.2024 KR 20240200596
(71) Applicant: LG Display Co., Ltd., Seoul, 07336 (KR)
(72) Inventor: YOO, ChoongKeun, 10845 Paju-si (KR); KO, Hyunil, 10845 Paju-si (KR)
(74) Representative: Poll, Christopher

(57) **Abstract**

According to an aspect of the present disclosure, there is provided a display device. The display device includes a substrate comprising a display area and a non-display area and a circuit film electrically connected to at least one side in the non-display area of the substrate. The circuit film includes a plurality of first via holes configured to overlap the non-display area and formed through the circuit film. Some of the plurality of first via holes are included in a first group. Some of the remaining first via holes are included in a second group. The plurality of first via holes included in the first and second groups are arranged in a direction between a first direction and a second direction that is a direction intersecting the first direction. The first and second groups are disposed alternately in the first direction. Therefore, the display device reduce the size of the non-display area.

## Description

### CROSS-REFERENCE TO RELATED APPLICATIONS

This application claims the priority of Korean Patent Application No. 10-2024-0200596 filed on December 30, 2024, in the Korean Intellectual Property Office, the disclosure of which is incorporated herein by reference.

### FIELD

The present specification relates to a display device, and more particularly, to a display device having a structure capable of decreasing a width of a non-display area.

### DESCRIPTION OF THE RELATED ART

Recently, electronic devices in display device fields, which visually display electrical information signals, have been rapidly developed in accordance with the full-fledged entry into the information era. Studies related to the display devices are being continuously conducted to minimize widths of bezel areas in order to improve aesthetic appearances.

### SUMMARY

An object to be achieved by the present specification is to provide a display device capable of reducing production energy by decreasing a size of a non-display area of a substrate included in the display device.

Objects of the present disclosure are not limited to the above-mentioned objects, and other objects, which are not mentioned above, can be clearly understood by those skilled in the art from the following descriptions.

According to an aspect of the present disclosure, there is provided a display device. The display device includes a substrate comprising a display area and a non-display area and a circuit film electrically connected to at least one side in the non-display area of the substrate. The circuit film includes a plurality of first via holes configured to overlap the non-display area and formed through the circuit film. Some of the plurality of first via holes are included in a first group. Some of the remaining first via holes are included in a second group. The plurality of first via holes included in the first and second groups are arranged in a direction between a first direction and a second direction that is a direction intersecting the first direction. The first and second groups are disposed alternately in the first direction. Alignment directions of the plurality of first via holes included in the first group are identical to one another. Alignment directions of the plurality of first via holes included in the second group are identical to one another.

Other detailed matters of the exemplary embodiments are included in the detailed description and the drawings.

According to the embodiment of the present specification, the display device includes the circuit film having the structure capable of decreasing the area in which the substrate and the circuit film of the display device overlap, which may decrease the size of the substrate and optimize the process of forming the substrate from the mother substrate.

According to the embodiment of the present specification, the object to be achieved by the present specification is to manufacture a lightweight circuit film by disposing the plurality of via holes in the circuit film having a limited area.

The effects of the present disclosure are not limited to the aforementioned effects, and other effects, which are not mentioned above, will be apparently understood to a person having ordinary skill in the art from the following description.

The objects to be achieved by the present disclosure, the means for achieving the objects, and the effects of the present disclosure described above do not specify essential features of the claims, and, thus, the scope of the claims is not limited to the disclosure of the present disclosure.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a top plan view schematically illustrating the display device according to the embodiment of the present specification;
FIG. 2 is a view schematically illustrating a cross-sectional structure taken along line a-b in FIG. 1;
FIG. 3 is a view schematically illustrating a top surface structure of a circuit film of the display device according to the embodiment of the present specification;
FIG. 4 is a view schematically illustrating a rear surface structure of the circuit film of the display device according to the embodiment of the present specification;
FIG. 5 is a top plan view illustrating a structure in which a substrate and the circuit film of the display device according to the embodiment of the present specification are connected;
FIG. 6 is a cross-sectional view taken along line A-A' in FIG. 5;
FIG. 7 is a cross-sectional view taken along line B-B' in FIG. 5;
FIG. 8 is a cross-sectional view taken along line C-C' in FIG. 5;
FIG. 9 is a cross-sectional view taken along line D-D' in FIG. 5;
FIG. 10 is a top plan view schematically illustrating a display device according to another embodiment of the present specification;
FIG. 11 is a view schematically illustrating a cross-sectional structure taken along line c-d in FIG. 10;
FIG. 12 is a view schematically illustrating a top surface structure of a circuit film of the display device according to another embodiment of the present specification;
FIG. 13 is a view schematically illustrating a rear surface structure of the circuit film of the display device according to another embodiment of the present specification;
FIG. 14 is a top plan view illustrating a structure in which a substrate and the circuit film of the display device according to another embodiment of the present specification are connected;
FIG. 15 is a cross-sectional view taken along line E-E' in FIG. 14;
FIG. 16 is a cross-sectional view taken along line F-F' in FIG. 14;
FIG. 17 is a cross-sectional view taken along line G-G' in FIG. 14;
FIG. 18 is a cross-sectional view taken along line H-H' in FIG. 14;
FIG. 19 is a top plan view schematically illustrating a display device according to still another embodiment of the present specification;
FIG. 20 is a top plan view schematically illustrating a circuit film in FIG. 19;
FIG. 21 is a view schematically illustrating a cross-sectional structure taken along line e-f in FIG. 19;
FIG. 22 is a top plan view illustrating a structure in which a substrate and the circuit film of the display device according to still another embodiment of the present specification are connected;
FIG. 23 is a cross-sectional view taken along line I-I' in FIG. 22.
FIG. 24 is a cross-sectional view taken along line J-J' in FIG. 22;
FIG. 25 is a cross-sectional view taken along line K-K' in FIG. 22;
FIG. 26 is a cross-sectional view taken along line L-L' in FIG. 22;
FIG. 27 is a top plan view schematically illustrating a display device according to yet another embodiment of the present specification;
FIG. 28 is a top plan view schematically illustrating a circuit film in FIG. 27;
FIG. 29 is a view schematically illustrating a cross-sectional structure taken along line g-h in FIG. 27;
FIG. 30 is a top plan view illustrating a structure in which a substrate and the circuit film of the display device according to yet another embodiment of the present specification are connected;
FIG. 31 is a cross-sectional view taken along line M-M' in FIG. 30;
FIG. 32 is a cross-sectional view taken along line N-N' in FIG. 30;
FIG. 33 is a cross-sectional view taken along line O-O' in FIG. 30;
FIG. 34 is a cross-sectional view taken along line P-P' in FIG. 30;
FIG. 35 is a top plan view schematically illustrating a display device according to still yet another embodiment of the present specification;
FIG. 36 is a top plan view schematically illustrating a circuit film in FIG. 35;
FIG. 37 is a view schematically illustrating a cross-sectional structure taken along line i-j in FIG. 35;
FIG. 38 is a top plan view illustrating a structure in which a substrate and the circuit film of the display device according to still yet another embodiment of the present specification are connected;
FIG. 39 is a cross-sectional view taken along line Q-Q' in FIG. 38;
FIG. 40 is a cross-sectional view taken along line R-R' in FIG. 38;
FIG. 41 is a cross-sectional view taken along line S-S' in FIG. 38;
FIG. 42 is a cross-sectional view taken along line T-T' in FIG. 38;
FIG. 43 is a top plan view schematically illustrating a display device according to a further embodiment of the present specification;
FIG. 44 is a top plan view schematically illustrating a circuit film in FIG. 43;
FIG. 45 is a view schematically illustrating a cross-sectional structure taken along line k-l in FIG. 43;
FIG. 46 is a top plan view illustrating a structure in which a substrate and the circuit film of the display device according to the further embodiment of the present specification are connected;
FIG. 47 is a cross-sectional view taken along line U-U' in FIG. 46;
FIG. 48 is a cross-sectional view taken along line V-V' in FIG. 46;
FIG. 49 is a cross-sectional view taken along line W-W' in FIG. 46; and
FIG. 50 is a cross-sectional view taken along line X-X' in FIG. 46.

### DETAILED DESCRIPTION

When the relation of a time sequential order is described using the terms such as "after", "continuously to", "next to", and "before", the order may not be continuous unless the terms are used with the term "immediately" or "directly".

In describing components of the exemplary embodiment of the present disclosure, terminologies such as first, second, A, B, (a), (b), and the like may be used. These terminologies are used to distinguish a component from the other component, but a nature, an order, or the number of the components is not limited by the terminology. When a component is "linked", "coupled", or "connected" to another component, the component may be directly linked or connected to the other component. However, unless specifically stated otherwise, it should be understood that a third component may be interposed between the components which may be indirectly linked or connected.

It should be understood that "at least one" includes all combinations of one or more of associated components. For example, "at least one of first, second, and third components" means that not only a first, second, or third component, but also all combinations of two or more of first, second, and third components are included.

In the present specification, a "display apparatus" may include a display apparatus which includes a display panel and a driver for driving the display panel, in a narrow sense, such as a liquid crystal module (LCM), an organic light emitting module (OLED module), and a quantum dot module. Further, the "display apparatus" may further include a set electronic apparatus or a set apparatus (or a set device) which is a complete product or a final product including an LCM, an OLED module, a QD module, etc., such as a notebook computer, a television, or a computer monitor, an automotive display apparatus or equipment display apparatus including another type of vehicle and a mobile electronic apparatus including a smart phone or an electronic pad.

Accordingly, the display apparatus of the present disclosure may include not only a display apparatus itself in a narrow sense such as an LCM, an OLED module, a QD module, etc., but also an applied product or a set apparatus which is a final consumer device including the LCD, the OLED module, the QD module, etc.

Further, in some cases, the LCM, the OLED module, or the QD module which is configured by a display panel and a driver may be represented as "a display apparatus" in a narrow sense and an electronic device as a complete product including the LCM, the OLED module, and the QD module may be represented as a "set apparatus". For example, the display apparatus in the narrow sense includes a liquid crystal (LCD) display panel, an OLED display panel, or a quantum dot display panel and a source PCB which is a controller for driving the display panel. In contrast, the set apparatus may be a concept further including a set PCB which is a set controller which is electrically connected to the source PCB to control the entire set apparatus.

As a display panel used in the exemplary embodiment of the present disclosure, any type of display panel such as a liquid crystal display panel, an organic light emitting diode (OLED) display panel, a quantum dot (QD) display panel, and an electroluminescent display panel may be used. The display panel of the present exemplary embodiment is not limited to a specific display panel in which a bezel is bent with a flexible substrate for the organic light emitting diode (OLED) display panel and a back plate support structure therebelow. Further, a display panel used for the display apparatus according to the exemplary embodiment of the present disclosure is not limited to a shape or a size of the display panel.

For example, when the display panel is an OLED display panel, the display panel may include a plurality of gate lines, data lines, and pixels formed at intersecting areas of the gate lines and/or data lines. Further, the display panel may be configured to include an array including a thin film transistor which is an element to selectively apply a voltage to each pixel, a light emitting diode layer on the array, an encapsulation substrate or an encapsulation layer, and the like disposed on the array so as to cover the light emitting diode layer. The encapsulation layer may protect the thin film transistor, the light emitting diode layer, and the like from external impacts and may suppress the permeation of moisture or oxygen into the light emitting diode layer. Further, a layer formed on the array may include an inorganic light emitting layer, for example, a nano-sized material layer quantum dots, or the like.

The features of various exemplary embodiments of the present disclosure can be partially or entirely coupled to or combined with each other and can be interlocked and operated in technically various ways, and the exemplary embodiments can be carried out independently of or in association with each other.

Hereinafter, the exemplary embodiment of the present disclosure will be described with reference to the accompanying drawings and exemplary embodiments as follows. Scales of components illustrated in the accompanying drawings are different from the real scales for the purpose of description, so that the scales are not limited to those illustrated in the drawings.

Hereinafter, an exemplary embodiment of the present disclosure will be described in detail with reference to the drawings. All the components of each display device/apparatus according to all embodiments of the present disclosure are operatively coupled and configured.

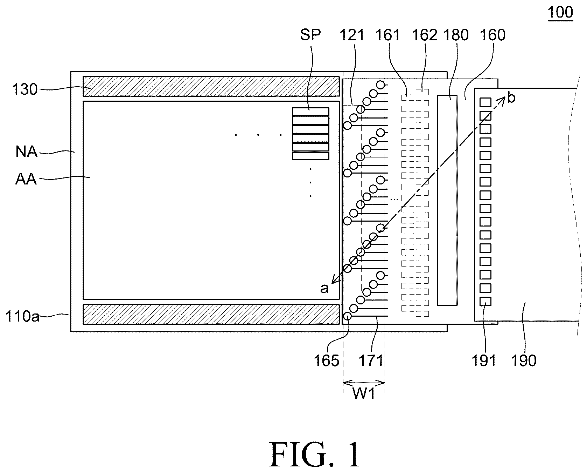

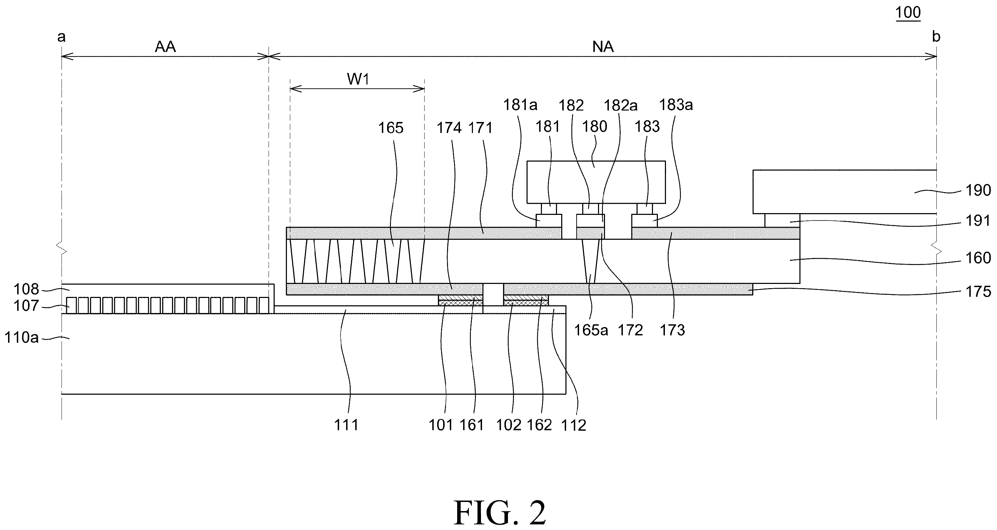

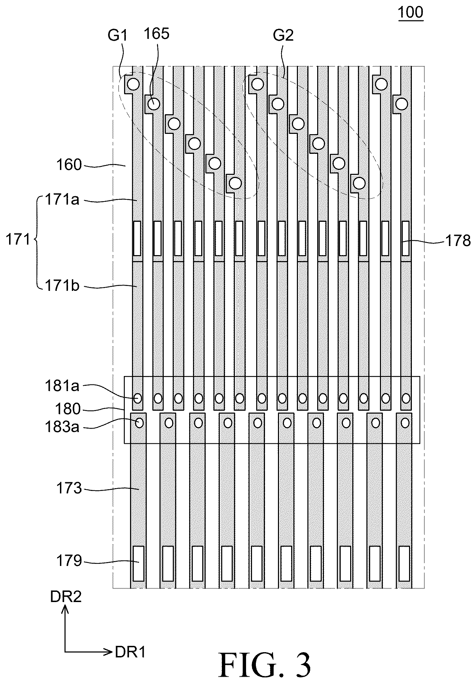

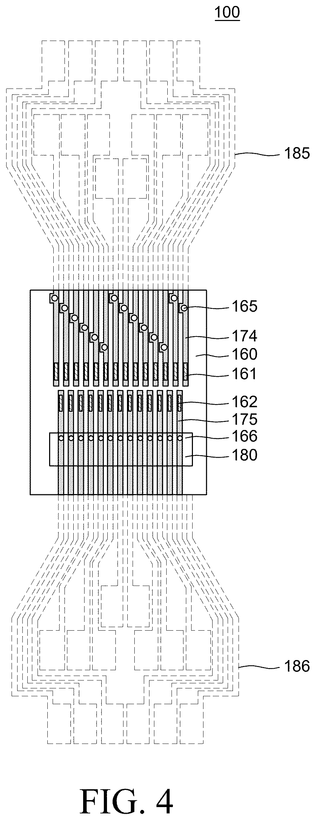

FIG. 1 is a top plan view schematically illustrating a display device according to an embodiment of the present specification. FIG. 2 is a view schematically illustrating a cross-sectional structure taken along line a-b in FIG. 1. FIG. 3 is a view schematically illustrating a top surface structure of a circuit film of the display device according to the embodiment of the present specification. FIG. 4 is a view schematically illustrating a rear surface structure of the circuit film of the display device according to the embodiment of the present specification.

With reference to FIGS. 1 to 4, a display device 100 according to an embodiment of the present specification may include a display panel 110 and a circuit film 160. The display panel 110 may include a display area AA, and a non-display area NA configured to surround the display area AA. A plurality of subpixels SP may be disposed in the display area AA. Organic light-emitting elements 107 may be disposed in each of the subpixels SP.

In addition, the display panel 110 may include a substrate 110a, and a cover glass 108 may be disposed on the substrate 110a and overlap all the plurality of subpixels SP. The substrate 110a may also include the display area AA and the non-display area NA identical to the areas of the display panel 110.

Gate drive circuits 130 may be disposed in a part of the non-display area NA. For example, the gate drive circuits 130 may be disposed on two side surfaces of the display panel 110. However, the present specification is not limited thereto. The gate drive circuit 130 may not be disposed in the display panel 110 or may be disposed only on one side surface of the display panel 110.

The circuit film 160 may be connected to a part of the non-display area NA of the display panel 110. The circuit film 160 may be electrically connected to at least one side of the non-display area NA that surrounds the display area AA of the substrate 110a.

However, for convenience of description, the following description is focused on a configuration in which the circuit film 160 is a film on which a source driver integrated circuit 180 is mounted. However, the present specification is not limited thereto. The circuit film 160 may be a film on which a general integrated circuit is mounted.

The circuit film 160 may overlap the non-display area NA of the substrate 110a. In addition, the circuit film 160 may overlap at least a part of a multiplexer circuit 121 disposed in the non-display area NA of the display panel 110. The multiplexer circuit 121 may include a multiplexer (MUX) configured to receive a high-potential voltage (e.g., an integrated circuit drive voltage (AVDDH)) and a low-potential voltage (e.g., a base voltage (GND)). The circuit film 160 may be positioned at one side of the display area AA. The circuit film 160 may be disposed in an area in which the gate drive circuit 130 is not disposed.

A plurality of first signal lines 171, a plurality of second signal lines 172, and a plurality of third signal lines 173 may be disposed on the circuit film 160. In addition, the source driver integrated circuit 180 may be mounted on the circuit film 160.

In addition, a printed circuit 190 may be connected to one side of the circuit film 160.

A plurality of fourth signal lines 174 and a plurality of fifth signal lines 175 may be disposed on a rear surface of the circuit film 160. Specifically, the first signal line 171 may be electrically connected to the fourth signal line 174, which is disposed on the rear surface of the circuit film 160, through a first via hole 165 disposed in the circuit film 160. The first via hole 165 may be formed through the circuit film 160.

The fourth signal line 174 may be electrically connected to a first routing line 111 disposed on the substrate 110a of the display device 100. For example, a first pad 101 connected to the first routing line 111 is electrically connected to a first connection pad 161 connected to the fourth signal line 174, such that the fourth signal line 174 and the first routing line 111 may be electrically connected. The fourth signal line 174 may be connected to the first pad 101 through the first connection pad 161.

In addition, the second signal line 172 may be electrically connected to the fifth signal line 175, which is disposed on the rear surface of the circuit film 160, through a second via hole 165a disposed in the circuit film 160. The second via hole 165a may be disposed in a middle area of the circuit film and disposed to be farther from the display area AA than the first via hole 165 from the display area AA.

The fifth signal line 175 may be electrically connected to a second routing line 112 disposed on the substrate 110a of the display device 100. For example, a second pad 102 connected to the second routing line 112 is electrically connected to a second connection pad 162 connected to the fifth signal line 175, such that the fifth signal line 175 and the second routing line 112 may be electrically connected. The fifth signal line 175 may be connected to the second pad 102 through the second connection pad 162.

Meanwhile, in a cross-sectional view, the first routing line 111 and the second routing line 112 disposed on the substrate 110a are illustrated as adjoining each other. However, the first routing line 111 and the second routing line 112 may be disposed to be substantially spaced apart from each other.

With reference to FIGS. 1 to 4, a first electrode pattern layer 181a may be disposed on a part of a top surface of each of the plurality of first signal lines 171, a second electrode pattern layer 182a may be disposed on a part of a top surface of each of the plurality of second signal lines 172, and a third electrode pattern layer 183a may be disposed on a part of a top surface of each of the plurality of third signal lines 173.

A first connection layer 181 electrically connected to the source driver integrated circuit 180 may be disposed on the first electrode pattern layer 181a, a second connection layer 182 electrically connected to the source driver integrated circuit 180 may be disposed on the second electrode pattern layer 182a, and a third connection layer 183 electrically connected to the source driver integrated circuit 180 may be disposed on the third electrode pattern layer 183a.

In addition, a third connection pad 191 may be disposed on a part of a top surface of the third signal line 173. The printed circuit 190 may be connected to the third connection pad 191. A line width of the third signal line 173 may be larger than a line width of the first signal line 171. However, the present specification is not limited thereto.

That is, the first signal line 171 may be electrically connected to the source driver integrated circuit 180 and electrically connected to the fourth signal line 174. In addition, the second signal line 172 may be electrically connected to the source driver integrated circuit 180 and electrically connected to the fifth signal line 175. In addition, the third signal line 173 may be electrically connected to the source driver integrated circuit 180 and electrically connected to the printed circuit 190.

The plurality of signal lines is disposed on one circuit film 160. The signal lines need to be efficiently designed and disposed to enable an operation of the display device 100. Therefore, the plurality of signal lines may be disposed on the top surface and the rear surface of the circuit film 160 of the display device 100.

However, the plurality of first signal lines 171 disposed on the top surface of the circuit film 160 needs to be respectively electrically connected to the plurality of fourth signal lines 174, and the plurality of second signal lines 172 needs to be respectively connected to the plurality of fifth signal lines 175.

In the display device 100 according to the embodiment of the present specification, the circuit film 160 may include the plurality of via holes 165 and 166 to electrically connect the different signal lines.

Specifically, the first signal line 171, which is disposed on the top surface of the circuit film 160, and the fourth signal line 174, which is disposed on the rear surface of the circuit film 160, may be electrically connected through the first via hole 165 formed through the circuit film 160.

The first via hole 165 may be filled with an electrically conductive material to electrically connect the first signal line 171 and the fourth signal line 174. For example, the electrically conductive material may be made of a single metal or an alloy including a plurality of metals.

The first via hole 165 may overlap the first signal line 171 and the fourth signal line 174. In addition, the second signal line 172, which is disposed on the top surface of the circuit film 160, and the fifth signal line 175, which is disposed on the rear surface of the circuit film 160, may be electrically connected through the second via hole 165a formed through the circuit film 160.

The second via hole 165a may be filled with an electrically conductive material to electrically connect the second signal line 172 and the fifth signal line 175. The electrically conductive material may be made of a single metal or an alloy including a plurality of metals.

The second via hole 165a may overlap the second signal line 172 and the fifth signal line 175. As described above, the first signal line 171 and the fourth signal line 174 are connected through the first via hole 165, and the second signal line 172 and the fifth signal line 175 are connected through the second via hole 165a, such that a separate electrode layer does not need to be formed to connect the signal lines, which simplifies the process.

In addition, the first via hole 165 overlaps the first signal line 171 and the fourth signal line 174, and the second via hole 165a overlaps the second signal line 172 and the fifth signal line 175, such that the area of the circuit film 160 may be efficiently utilized. In particular, in case that the display device 100 is a mobile device or the like, a size of the substrate 110a of the display device 100 may be small, and an area of the circuit film 160 connected to one side of the substrate 110a may also be small.

The plurality of first via holes 165 and the plurality of second via holes 165a provided in the circuit film 160 of the display device 100 according to the embodiment of the present specification may serve to efficiently connect the plurality of signal lines even though the area of the circuit film 160 is small.

The plurality of first via holes 165 may be disposed in the circuit film 160 and grouped into a plurality of groups G1 and G2. For example, the plurality of first via holes 165 may include a first group G1 and a second group G2. Some of the plurality of first via holes 165 may be included in the first group G1, and some of the remaining first via holes 165 may be included in the second group G2. A plurality of first via holes 165 may be included in each of the first group G1 and the second group G2.

The plurality of first via holes 165 included in the first group G1 may be arranged in a direction between a first direction DR1 and a second direction DR2 that is a direction intersecting the first direction DR1. In this case, the first direction DR1 may be a direction perpendicular to a direction in which one first signal line 171 extends, and the second direction DR2 may be the direction in which one first signal line 171 extends.

The plurality of first via holes 165 included in the first group G1 may be disposed so as not to overlap one another in the first direction DR1 and the second direction DR2.

The plurality of first via holes 165 included in the second group G2 may be arranged in the same way as the plurality of first via holes 165 included in the first group G1. For example, the plurality of first via holes 165 included in the second group G2 may be arranged in a direction intersecting the first direction DR1 and the second direction DR2.

The plurality of first via holes 165 included in the second group G2 may be disposed so as not to overlap one another in the first direction DR1 and the second direction DR2.

The arrangement of the plurality of first via holes 165 included in the first group G1 and the arrangement of the plurality of first via holes 165 included in the second group G2 may be identical to each other. In addition, one of the plurality of first via holes 165 included in the first group G1 may overlap one of the plurality of first via holes 165 included in the second group G2 in the first direction DR1.

For example, the first via hole 165, which is disposed in a first row of the first group G1, and the first via hole 165, which is disposed in a first row of the second group G2, may be disposed to overlap each other in the first direction DR1, and the first via hole 165, which is disposed in a second row of the first group G1, and the first via hole 165, which is disposed in a second row of the second group G2, may be disposed to overlap each other in the first direction DR1. In this case, the first row and the second row may be arranged in the first direction DR1.

A distance in the first direction DR1 between the first via hole 165 disposed in the first row of the first group G1 and the first via hole 165 disposed in the first row of the second group G2 may be equal to a distance in the first direction DR1 between the first via hole 165 disposed in the second row of the first group G1 and the first via hole 165 disposed in the second row of the second group G2.

In addition, the plurality of first groups G1 and the plurality of second groups G2 including the plurality of first via holes 165 may be disposed on the circuit film 160, and the plurality of first groups G1 and the plurality of second groups G2 may be arranged in the first direction DR1. As described above, the plurality of first via holes 165 disposed in the circuit film 160 are arranged regularly, which may decrease a first width W1 of an area of the circuit film 160 occupied by the plurality of first via holes 165. In this case, the first width W1 may refer to a straight distance in the first direction DR1 from the first via hole 165, which is disposed to be closest to the display area AA among the plurality of first via holes 165, to the first via hole 165 disposed to be closest to the first connection pad 161.

For example, the first width W1 may decrease to 0.7 times a width in the first direction DR1 of the non-display area NA disposed on the circuit film 160. For example, in case that the width in the first direction DR1 of the non-display area NA disposed on the circuit film 160 is 4 mm, the first width W1 may decrease to 2.8 mm or less.

The plurality of first via holes 165 may be disposed between the source driver integrated circuit 180 and the display area AA of the display panel 110. The plurality of first via holes 165 may be disposed to overlap a part of the non-display area NA of the substrate 110a. The area in which the circuit film 160 and the non-display area NA of the substrate 110a overlap may increase as the area of the circuit film 160 occupied by the plurality of first via holes 165 increases.

In this case, the area of the non-display area NA of the substrate 110a may increase, and the size of the substrate 110a may increase. Therefore, there is a problem in that the non-display area NA of the display device 100 or a bezel size increases, which may increase costs required to manufacture the display device 100.

However, in the display device 100 according to the embodiment of the present specification, the plurality of first via holes 165 is disposed to be grouped into the plurality of groups G1 and G2, which may decrease the first width W1 of the circuit film 160 that overlaps the non-display area NA of the substrate 110a.

Therefore, it is possible to reduce the costs required to manufacture the display device 100. Specifically, the substrate 110a used for one display device 100 may be made by cutting a large-area mother substrate. In this case, the number of substrates 110a obtained from the mother substrate may decrease as the size of the substrate 110a used for one display device 100 increases. In this case, the costs required to manufacture the display device 100 are increased. In the display device according to the embodiment of the present specification, the first width W1 of the circuit film 160, which overlaps the non-display area NA of the substrate 110a, is decreased, such that the width of the non-display area NA of the substrate 110a may decrease, and the number of substrates 110a obtained from the mother substrate may increase.

Meanwhile, as illustrated in FIG. 3, at least some of the plurality of first signal lines 171 disposed on the top surface of the circuit film 160 may include a plurality of signal sub-lines.

In case that the first signal line 171 includes the plurality of signal sub-lines, the first signal line 171 may include a first signal sub-line 171a, and a second signal sub-line 171b connected to the first signal sub-line 171a. The first signal sub-line 171a may be disposed to be closer to the display area AA than the second signal sub-line 171b to the display area AA. The first signal sub-line 171a and the second signal sub-line 171b may be electrically connected through the connection area 178. Pads may be disposed in the connection area 178.

In case that the first signal line 171 includes the plurality of signal sub-lines, the first via hole 165 may be connected to the first signal sub-line 171a. That is, the first signal sub-line 171a may be electrically connected to the fourth signal line 174 through the first via hole 165. In addition, in case that the first signal line 171 includes the plurality of signal sub-lines, the second via hole 165a may be connected to the second signal sub-line 171b. That is, the second signal sub-line 171b may be connected to the first electrode pattern layer 181a. However, the structure of the first signal line 171 is not limited thereto. The first signal line 171 may be configured as a slight line without including the plurality of signal sub-lines.

With reference to FIG. 4, the plurality of fourth signal lines 174, which are connected to the plurality of first signal lines 171 through the first via holes 165, and the plurality of fifth signal lines 175, which are connected to the plurality of second signal lines 172 through the second via holes 165a, may be disposed on the rear surface of the circuit film 160.

As described above, because the plurality of signal lines are disposed on the top surface and the rear surface of the circuit film 160, a test needs to be performed to identify whether the signal lines operate normally.

Therefore, before the signal lines are connected to the substrate 110a of the display device 100, first inspection patterns 185 may be respectively connected to the plurality of fourth signal lines 174 disposed on the rear surface of the circuit film 160, second inspection patterns 186 may be respectively connected to the plurality of fifth signal lines 175, and the test may be performed to identify whether the signal lines are normal. The plurality of first inspection patterns 185 and the plurality of second inspection patterns 186 electrically connected to the fourth signal lines 174 and the fifth signal lines 175 disposed on the circuit film 160 may be removed after the test is completed.

After the test for the circuit film 160, the first connection pad 161 connected to the fourth signal line 174 may be disposed on the first pad 101 disposed on the substrate 110a, and the second connection pad 162 connected to the fifth signal line 175 may be disposed on the second pad 102 disposed on the substrate 110a. Therefore, the circuit film 160, which operates normally, may be electrically connected to the first pad 101 and the second pad 102 disposed on the substrate 110a, such that the display device 100 may be configured.

At least one first pad 101 and at least one first connection pad 161 may each be disposed to be closer to the display area AA than each of at least one second pad 102 and at least one second connection pad 561 to the display area AA.

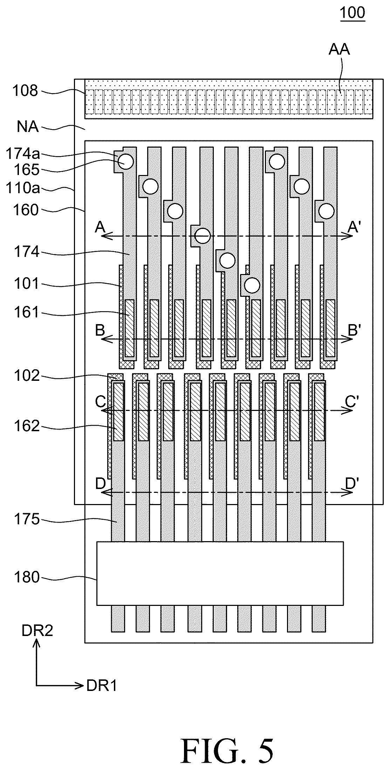

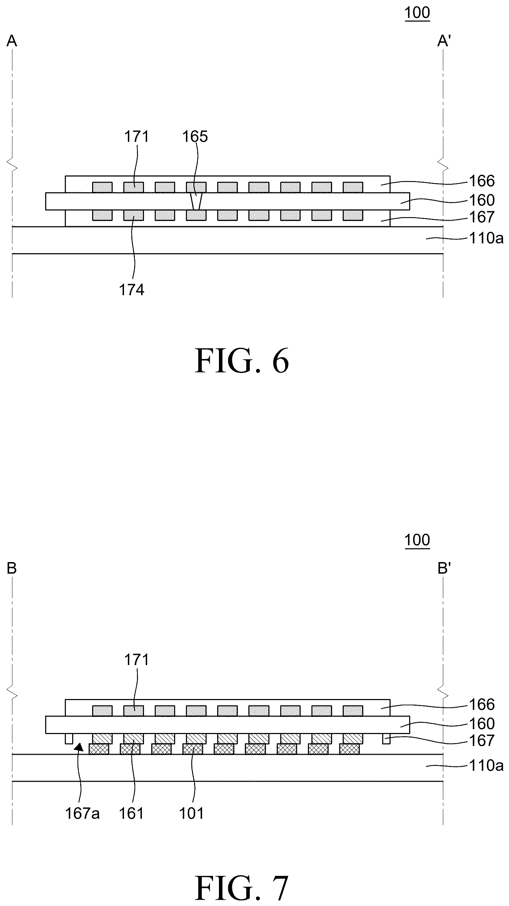

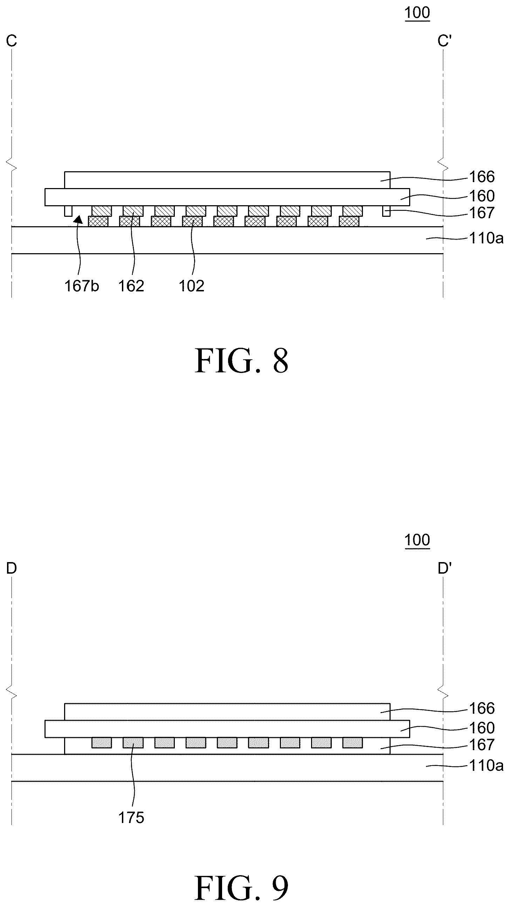

FIG. 5 is a top plan view illustrating a structure in which the substrate and the circuit film of the display device according to the embodiment of the present specification are connected. FIG. 6 is a cross-sectional view taken along line A-A' in FIG. 5. FIG. 7 is a cross-sectional view taken along line B-B' in FIG. 5. FIG. 8 is a cross-sectional view taken along line C-C' in FIG. 5. FIG. 9 is a cross-sectional view taken along line D-D' in FIG. 5.

With reference to FIGS. 5 to 9, the circuit film 160 may be disposed on a part of the top surface of the substrate 110a of the display device 100. The plurality of fourth signal lines 174 and the plurality of fifth signal lines 175 may be disposed on the rear surface of the circuit film 160.

The plurality of fourth signal lines 174 may be respectively connected to the first via holes 165.

At least one of the plurality of first via holes 165 may overlap the first pad 101. The plurality of first via holes 165, which serves to connect the plurality of fourth signal lines 174 to the plurality of first signal lines 171, are disposed in the circuit film 160, such that the plurality of first via holes 165 may overlap a plurality of components, and a limited area of the circuit film 160 may be efficiently utilized. However, the present specification is not limited thereto. The plurality of first via holes 165 may not overlap the first pads 101.

The plurality of first via holes 165 may be disposed on the substrate 110a of the display device 100. Specifically, with reference to FIGS. 5 and 6, the circuit film 160 may be disposed on the substrate 110a.

The plurality of first signal lines 171 may be disposed on the top surface of the circuit film 160, and a first protective layer 166 disposed on the first signal lines 171 and the circuit film 160 may be disposed on the top surface of the circuit film 160. The first protective layer 166 may include an organic insulating material. Although not illustrated in the drawings, the first protective layer 166 may include an open area that exposes a part of the top surface of the first signal line 171. For example, the first protective layer 166 may include the open area provided in an area in which the first signal line 171 is connected to the source driver integrated circuit 180.

The plurality of fourth signal lines 174 may be disposed on the rear surface of the circuit film 160, and a second protective layer 167 disposed on the fourth signal lines 174 and the rear surface of the circuit film 160 may be disposed on the rear surface of the circuit film 160. The second protective layer 167 may include an organic insulating material.

At least one first signal line 171 may be electrically connected to one fourth signal line 174 by the first via hole 165 formed through the circuit film 160.

With reference to FIG. 5, a width of an area 174a of each of the plurality of fourth signal lines 174, which overlaps the first via hole 165, may be larger than a width of an area that does not overlap the first via hole 165. In this case, the width of the fourth signal line 174 refers to a length in the first direction DR1. Therefore, it is possible to ensure a margin required to form the first via hole 165.

With reference to FIGS. 5 and 7, the plurality of fourth signal lines 174 may be respectively connected to the first connection pads 161. The plurality of first connection pads 161 may be respectively connected to the plurality of first pads 101 disposed on the top surface of the substrate 110a of the display device 100.

Specifically, the second protective layer 167 disposed on the rear surface of the circuit film 160 may include first open areas 167a to connect the fourth signal lines 174 and the first pads 101.

The first open areas 167a may overlap the plurality of first connection pads 161. That is, a rear surface and a side surface of each of the plurality of first connection pads 161 may not partially overlap the second protective layer 167. The plurality of first connection pads 161 needs to be at least partially in contact with the first pads 101 so that the plurality of first connection pads 161 are respectively connected directly to the first pads 101.

The plurality of first connection pads 161 are disposed to be spaced apart from one another, but the spacing distances may be short. In this case, it is difficult to form the first open areas 167a, which respectively correspond to the plurality of first connection pads 161, on the second protective layer 167. For example, at least one of the plurality of first connection pads 161 may not be consistent in position with at least one of the first open areas 167a formed on the second protective layer 167 while corresponding to the plurality of first connection pads 161. For this reason, at least one first connection pad 161 may not be connected to the first pad 101. In the circuit film 160 of the display device 100 according to the embodiment of the present specification, the first open areas 167a of the second protective layer 167 are disposed to overlap the plurality of first connection pads 161, such that the plurality of first connection pads 161 may be respectively stably connected to the first pads 101.

In addition, with reference to FIGS. 5 and 8, the plurality of fifth signal lines 175 may be respectively connected to the second connection pads 162. The plurality of second connection pads 162 may be respectively connected to the plurality of second pads 102 disposed on the top surface of the substrate 110a of the display device 100.

Specifically, the second protective layer 167, which is disposed on surfaces of the second connection pads 162 and the rear surface of the circuit film 160, may include second open areas 167b to connect the second connection pads 162 and the second pads 102. The second open areas 167b may overlap the plurality of second connection pads 162. That is, a rear surface and a side surface of each of the plurality of second connection pads 162 may not partially overlap the second protective layer 167.

The plurality of second connection pads 162 needs to be at least partially in contact with the second pads 102 so that the plurality of second connection pads 162 are respectively connected directly to the second pads 102. The second open areas 167b of the second protective layer 167 disposed on the rear surface of the circuit film 160 are disposed to overlap the plurality of second connection pads 162, such that the plurality of second connection pads 162 may be respectively stably connected to the second pads 102.

At least a part of the area in which the second connection pads 162 are in contact with the second pads 102 may include an area in which the fifth signal lines 175 and the other signal lines do not overlap. In an area in which the second connection pads 162 and the first signal lines 171, which are disposed on the top surface of the circuit film 160, do not overlap, the first protective layer 166 may be disposed on the top surface of the circuit film 160.

In addition, with reference to FIGS. 5 and 9, in at least a part of an area in which the fifth signal lines 175 are not in contact with the second pads 102, rear surfaces and side surfaces of the fifth signal lines 175 may be surrounded by the second protective layer 167. In addition, at least a part of the area of the fifth signal lines 175 except for the area in which the second connection pads 162 are in contact with the second pads 102 may include an area in which the fifth signal lines 175 do not overlap the other signal lines. In this case, the first protective layer 166 may be disposed on the top surface of the circuit film 160.

FIGS. 5, 7, and 8 illustrate structures in which a part of each of the first connection pads 161 of the plurality of fourth signal lines 174 overlaps a part of each of the first pads 101, and a part of each of the second connection pads 162 of the plurality of fifth signal lines 175 overlaps a part of each of the second pads 102. However, the present specification is not limited thereto.

For example, each of the first connection pads 161 of the plurality of fourth signal lines 174 may completely overlap each of the plurality of first pads 101, and each of the second connection pads 162 of the plurality of fifth signal lines 175 may completely overlap each of the plurality of second pads 102.

In addition, FIG. 6 illustrates only the plurality of first pads 101 and the plurality of second pads 102 disposed on the substrate 110a. However, the plurality of first pads 101 may be respectively connected to the plurality of first routing lines 111, and the plurality of second pads 102 may be respectively connected to the plurality of second routing lines 112.

As described above, in the display device 100 according to the embodiment of the present specification, the plurality of first via holes 165 are disposed to be grouped into the plurality of groups G1 and G2, which may decrease the width W1 of the circuit film 160 that overlaps the non-display area NA of the substrate 100a.

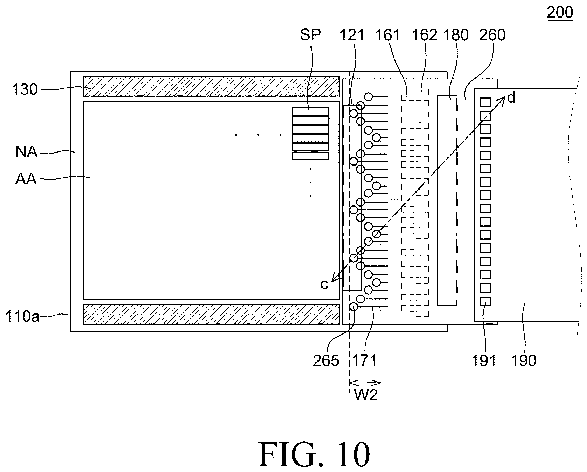

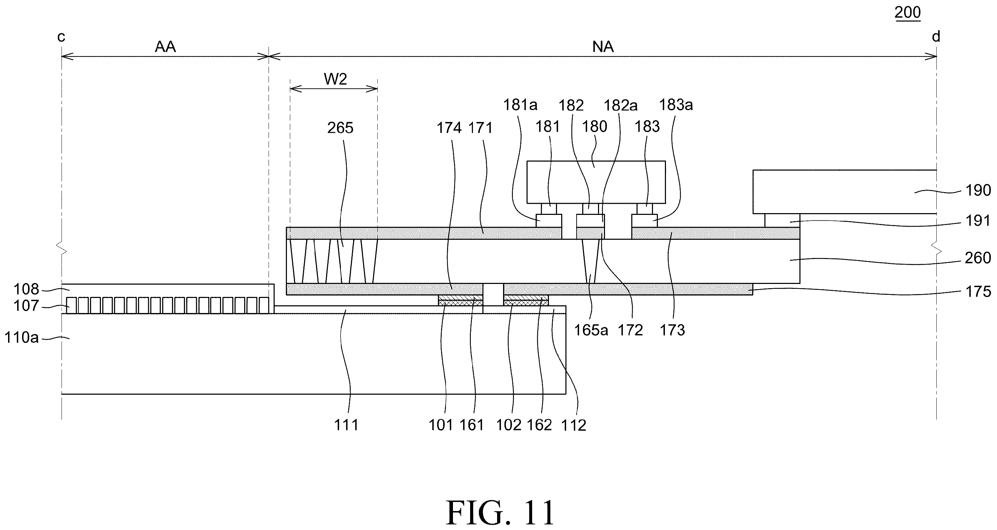

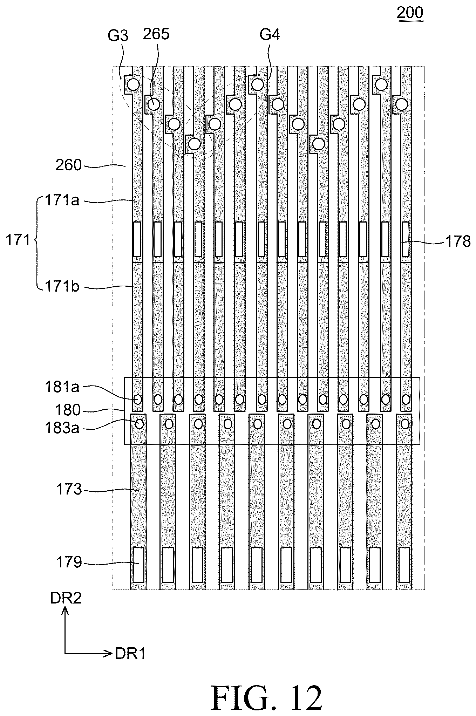

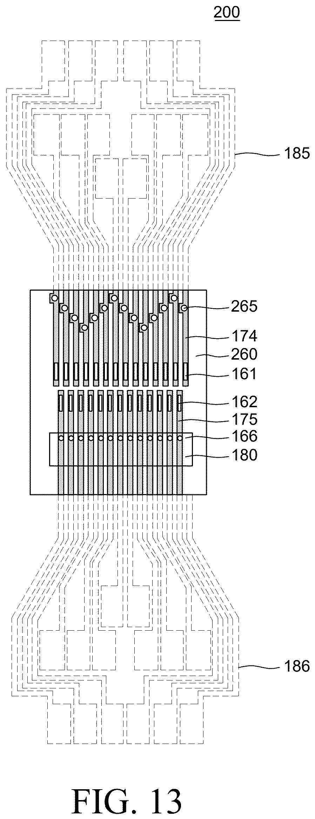

FIG. 10 is a top plan view schematically illustrating a display device according to another embodiment of the present specification. FIG. 11 is a view schematically illustrating a cross-sectional structure taken along line c-d in FIG. 10. FIG. 12 is a view schematically illustrating a top surface structure of a circuit film of the display device according to another embodiment of the present specification. FIG. 13 is a view schematically illustrating a rear surface structure of the circuit film of the display device according to another embodiment of the present specification.

A display device 200 in FIGS. 10 to 13 is substantially identical in configuration to the display device 100 in FIGS. 1 to 4, except for an arrangement of a plurality of first via holes 265. Therefore, repeated descriptions of the identical components will be omitted or may be briefly provided.

With reference to FIGS. 10 to 13, the plurality of first via holes 265 of the display device 200 may be disposed in a circuit film 260 and grouped into a plurality of groups G3 and G4. For example, the plurality of first via holes 265 may include a third group G3 and a fourth group G4. A plurality of first via holes 265 may be included in each of the third group G3 and the fourth group G4.

The plurality of first via holes 265 included in the third group G3 may be arranged in a direction between the first direction DR1 and the second direction DR2. The plurality of first via holes 265 included in the fourth group G4 may be arranged in the direction between the first direction DR1 and the second direction DR2.

One of the plurality of first via holes 265 included in the third group G3 may be included in the fourth group G4. Except for one first via hole 265 included in the third group G3 and the fourth group G4, a direction in which the plurality of first via holes 265 included in the third group G3 are arranged may be different from a direction in which the plurality of first via holes 265 included in the fourth group G4 are arranged.

For example, except for one first via hole 265 included in the third group G3 and the fourth group G4, the direction in which the plurality of first via holes 265 included in the third group G3 are arranged may intersect the direction in which the plurality of first via holes 265 included in the fourth group G4 are arranged. One of the plurality of first via holes 265 included in the third group G3 may overlap one of the plurality of first via holes 265 included in the fourth group G4 in the first direction DR1.

For example, the first via hole 265, which is disposed in a first row of the third group G3, and the first via hole 265, which is disposed in a first row of the fourth group G4, may be disposed to overlap each other in the first direction DR1, and the first via hole 265, which is disposed in a second row of the third group G3, and the first via hole 265, which is disposed in a second row of the fourth group G4, may be disposed to overlap each other in the first direction DR1. In this case, the first row and the second row may be arranged in the first direction DR1.

A distance in the first direction DR1 between the first via hole 265 disposed in the first row of the third group G3 and the first via hole 265 disposed in the first row of the fourth group G4 may be different from a distance in the first direction DR1 between the first via hole 265 disposed in the second row of the third group G3 and the first via hole 265 disposed in the second row of the fourth group G4.

For example, the distance in the first direction DR1 between the first via hole 265 disposed in the first row of the third group G3 and the first via hole 265 disposed in the first row of the fourth group G4 may be longer than the distance in the first direction DR1 between the first via hole 265 disposed in the second row of the third group G3 and the first via hole 265 disposed in the second row of the fourth group G4.

The two adjacent third groups G3 and the two adjacent fourth groups G4 may define a 'W' shape in a plan view.

The plurality of third groups G3 and the plurality of fourth groups G4 including the plurality of first via holes 265 may be disposed on the circuit film 260, and the plurality of third groups G3 and the plurality of fourth groups G4 may be disposed alternately and arranged in the first direction DR1.

As described above, the plurality of first via holes 265 disposed in the circuit film 260 are arranged regularly, which may decrease a second width W2 of an area of the circuit film 260 occupied by the plurality of first via holes 265. In this case, the second width W2 may refer to a straight distance in the first direction DR1 from the first via hole 265, which is disposed to be closest to the display area AA among the plurality of first via holes 265, to the first via hole 265 disposed to be closest to the first connection pad 161.

For example, the second width W2 may decrease to 0.37 to 0.38 times a width in the first direction DR1 of the non-display area NA disposed on the circuit film 260. For example, in case that the width in the first direction DR1 of the non-display area NA disposed on the circuit film 260 is 4 mm, the first width W1 may decrease to 1.5 mm or less.

In the display device according to another embodiment of the present specification, the second width W2 of the circuit film 160, which overlaps the non-display area NA of the substrate 110a, is decreased, such that the width of the non-display area NA of the substrate 110a may decrease, and the number of substrates 110a obtained from the mother substrate may increase.

Meanwhile, the display panel 110 including the plurality of organic light-emitting elements 107 may be disposed on a part of the substrate 110a, and the cover glass 108 may be disposed to cover the display panel 110. An area in which the circuit film 260 overlaps the substrate 110a increases as the second width W2 of the circuit film 260 increases. For this reason, interference, such as contact between the circuit film 260 and the cover glass 108, may occur, which may damage the circuit film 260.

In the display device 200 according to another embodiment of the present specification, at least some of the plurality of first via holes 265 are arranged in a 'W' shape, which may decrease the second width W2 of the circuit film 260 that overlaps the non-display area NA of the substrate 110a. Therefore, it is possible not only to decrease the size of the non-display area NA of the substrate 110a but also to reduce interference between the circuit film 260 and the cover glass 108.

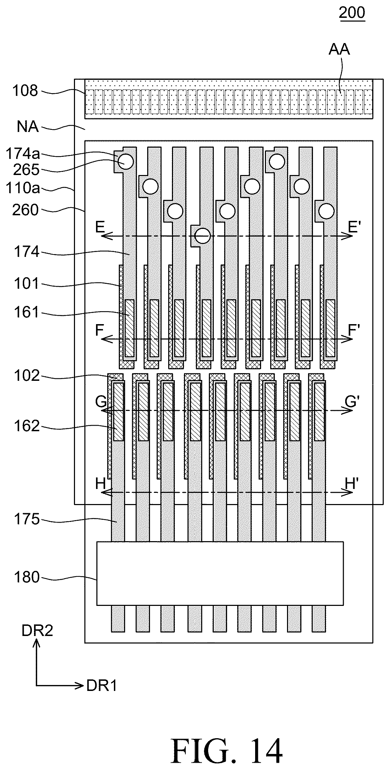

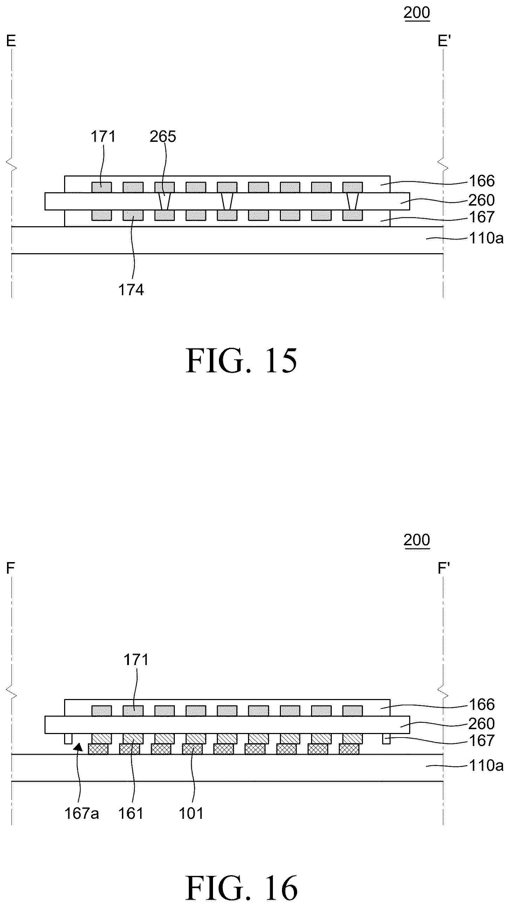

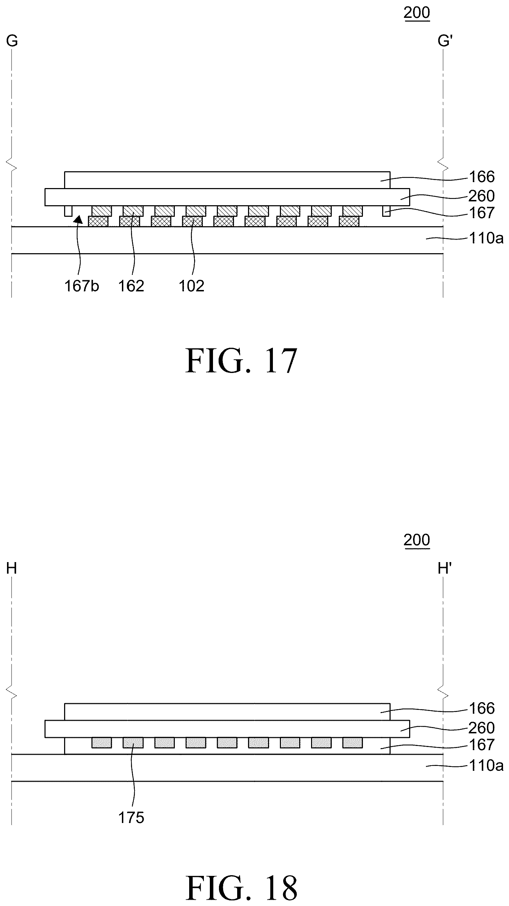

FIG. 14 is a top plan view illustrating a structure in which the substrate and the circuit film of the display device according to another embodiment of the present specification are connected. FIG. 15 is a cross-sectional view taken along line E-E' in FIG. 14. FIG. 16 is a cross-sectional view taken along line F-F' in FIG. 14. FIG. 17 is a cross-sectional view taken along line G-G' in FIG. 14. FIG. 18 is a cross-sectional view taken along line H-H' in FIG. 14.

The display device 200 in FIGS. 14 to 18 is substantially identical in configuration to the display device 100 in FIGS. 6 to 10, except for the arrangement of the plurality of first via holes 265. Therefore, repeated descriptions of the identical components will be omitted or may be briefly provided.

With reference to FIGS. 14 to 18, because the plurality of first via holes 265 disposed on the rear surface of the circuit film 260 are arranged in a plurality of 'W' shapes in a plan view, the number of first via holes 265, which are disposed on the circuit film 260 per unit area, may be larger than the number of first via holes 165 provided in the circuit film 260 of the display device 200. As described above, the plurality of first via holes 265 may be variously arranged, such that the size of the area in which the substrate 110a and the circuit film 260 of the display device 200 overlap may be adjusted.

In addition, a partial area of the second protective layer 167 disposed on the rear surface of the circuit film 260 includes first open areas 167a, such that the first connection pads 161 of the fourth signal lines 174 may be easily in contact with the first pads 101 disposed on the substrate 110a. In addition, the first open areas 167a of the second protective layer 167 overlap the plurality of first connection pads 161, such that the process of forming the first open areas 167a may be simplified, and the process reliability may be improved.

A partial area of the second protective layer 167 disposed on the rear surface of the circuit film 260 includes second open areas 167b, such that the second connection pads 162 of the fifth signal lines 175 may be easily in contact with the second pads 102 disposed on the substrate 110a. In addition, the second open areas 167b of the second protective layer 167 overlap the plurality of second connection pads 162, such that the process of forming the second open area 167b may be simplified, and the process reliability may be improved.

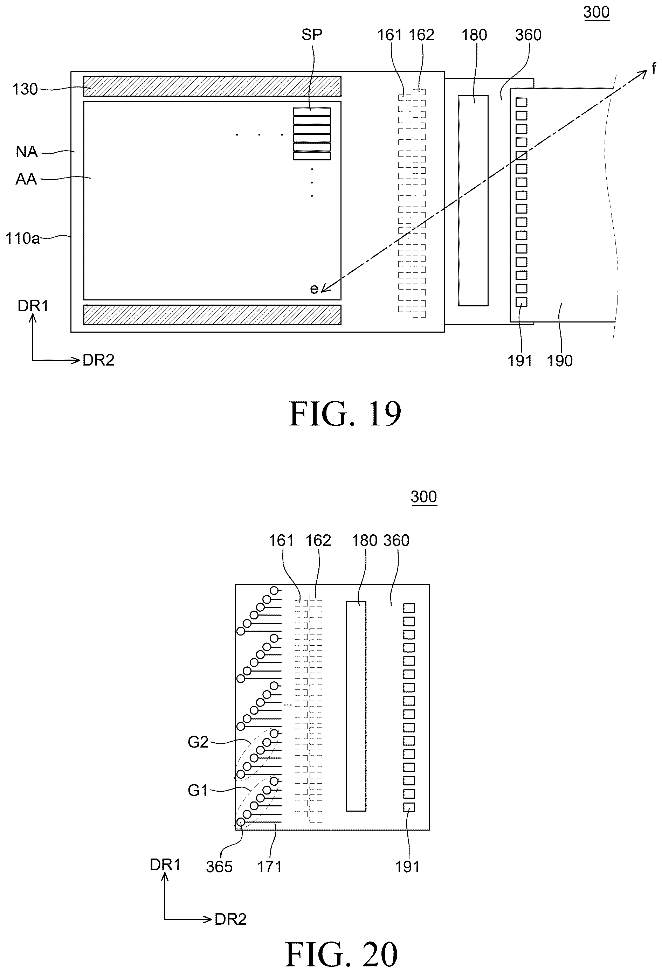

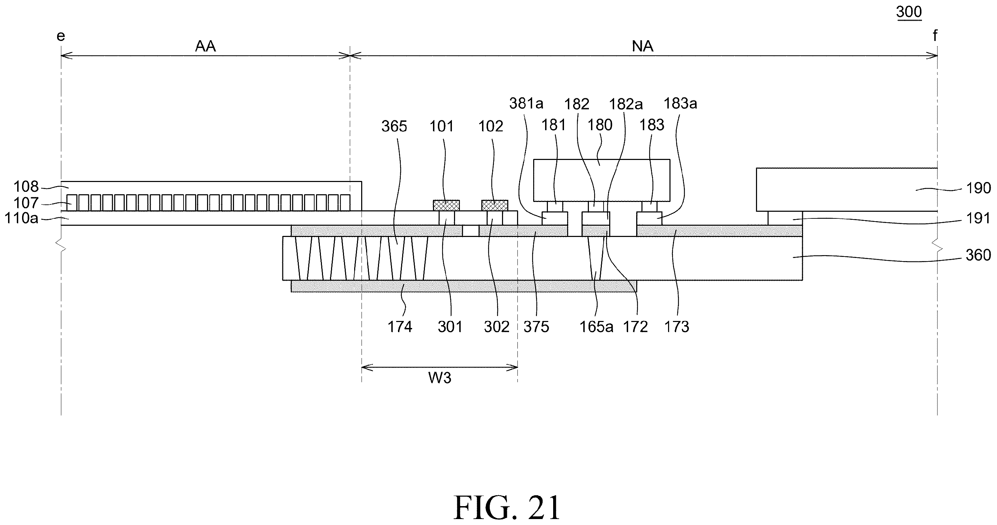

FIG. 19 is a top plan view schematically illustrating a display device according to still another embodiment of the present specification. FIG. 20 is a top plan view schematically illustrating a circuit film in FIG. 19. FIG. 21 is a view schematically illustrating a cross-sectional structure taken along line e-f in FIG. 19.

A display device 300 in FIGS. 19 to 21 is substantially identical in configuration to the display device 100 in FIGS. 1 and 2, except for a position of the circuit film 160, connection positions of the circuit film 160 and the substrate 110a, a configuration for electrically connecting the circuit film 160 and the substrate 110a, and positions of fifth signal lines 375 disposed on the circuit film 160. Therefore, repeated descriptions of the identical components will be omitted or may be briefly provided.

With reference to FIGS. 19 to 21, a circuit film 360 of the display device 300 may be a film on which the source driver integrated circuit (SDIC) 180 is mounted, or the circuit film 360 may be a printed circuit board on which a timing controller 140 is mounted. In case that the circuit film 160 is the printed circuit board, the source driver integrated circuit 180 may be disposed in the non-display area **NA** of the substrate 110a.

Specifically, a part of the circuit film 360 may be disposed below the substrate 110a. The integrated circuit 180 may be mounted on the circuit film 360, and at least a part of the integrated circuit 180 may not overlap the substrate 110a.

The plurality of first signal lines 171, the plurality of second signal lines 172, the plurality of third signal lines 173, and the plurality of fifth signal lines 375 may be disposed on the top surface of the circuit film 360. A plurality of fourth signal lines 374 may be disposed on the rear surface of the circuit film 360.

The plurality of first signal lines 171 may be respectively electrically connected to the plurality of fourth signal lines 374 through first via holes 365. The plurality of first signal lines 171 may be respectively electrically connected to the plurality of first pads 101 disposed on the top surface of the substrate 110a.

Specifically, a plurality of third via holes 301 may be provided in the substrate 110a and formed through the substrate 110a in an area that overlaps the plurality of first pads 101. The plurality of third via holes 301 may each be filled with an electrically conductive material.

The plurality of fifth signal lines 375 may be respectively electrically connected to the plurality of second pads 102 disposed on the top surface of the substrate 110a. Specifically, a plurality of fourth via holes 302 may be provided in the substrate 110a and formed through the substrate 110a in an area that overlaps the plurality of second pads 102. The plurality of fourth via holes 302 may each be filled with an electrically conductive material.

The plurality of fifth signal lines 375 may be respectively electrically connected to the plurality of fourth signal lines 174, which are disposed on the rear surface of the circuit film 360, through the plurality of via holes disposed in the circuit film 360.

Alternatively, the plurality of second signal lines 172 may be respectively electrically connected to the plurality of fourth signal lines 174, which are disposed on the rear surface of the circuit film 360, through the plurality of via holes disposed in the circuit film 360.

A fourth electrode pattern layer 381a may be disposed on a part of a top surface of each of the plurality of fifth signal lines 375. The first connection layer 181 electrically connected to the source driver integrated circuit 180 may be disposed on the fourth electrode pattern layer 381a.

That is, the first signal line 171 may be electrically connected to the first pad 101, which is disposed on the substrate 110a, and electrically connected to the fourth signal line 174. In addition, the fifth signal line 575 may be electrically connected to the second pad 102, which is disposed on the substrate 110a, and electrically connected to the source driver integrated circuit 180.

Meanwhile, the first pad 101 may be disposed on the substrate 110a and connected to the first routing line electrically connected to a data line disposed in the display area AA. In addition, the second pad 102 may be disposed on the substrate 110a and connected to the second routing line electrically connected to another data line disposed in the display area AA. The plurality of first signal lines 171 and the plurality of fifth signal lines 375 disposed on the top surface of the circuit film 360 may be electrically connected, on the rear surface of the substrate 110a, to the first pads 101 and the second pads 102 by the plurality of third via holes 301 and the plurality of fourth via holes 302 provided in the substrate 110a.

Therefore, some of the plurality of signal lines, which are disposed on the circuit film 360, and the plurality of first via holes 365 may overlap a part of the display area AA.

The display device 300 according to still another embodiment of the present specification may include the source driver integrated circuit 180 mounted on the circuit film 360, the first signal lines 171 may be electrically connected to the third via holes 301, and the fifth signal lines 375 may be electrically connected to the fourth via holes 302. In addition, the fifth signal line 375 may be electrically connected to the source driver integrated circuit 180. Further, the plurality of third via holes 301 and the plurality of fourth via holes 302 may be positioned to be farther from the display area AA than the plurality of first via holes 365 from the display area AA.

The plurality of first via holes 365 may be disposed in the circuit film 360 and grouped into a plurality of groups G1 and G2. For example, the plurality of first via holes 365 may include the first group G1 and the second group G2, and the first group G1 and the second group G2 may be arranged while having the same regularity as the arrangement of the plurality of first via holes 165 described with reference to FIGS. 1 to 4.

In case that the circuit film 360 is disposed on the top surface of the substrate 110a, the circuit film 360 may be disposed in the non-display area NA. In case that the circuit film 360 is disposed in the display area AA, a defect may occur. In particular, the circuit film 360 may interfere with a cover window 108 disposed in the entire the display area AA and a part of the non-display area NA.

Because the circuit film 360 of the display device 300 according to still another embodiment of the present specification is electrically connected to the rear surface of the substrate 110a, a defect caused by interference between the circuit film 360 and the cover window 108 may not occur even though the circuit film 360 is disposed to overlap the cover window 108.

In addition, because the circuit film 360 is connected to the rear surface of the substrate 110a through the plurality of third via holes 301 and the plurality of fourth via holes 302, the circuit film 360 does not cover the display area AA even though the circuit film 360 overlaps the display area AA. Therefore, it is possible to decrease a width of the side surface of the substrate 110a connected to the circuit film 360. In this case, the width of the side surface of the substrate 110a connected to the circuit film 360 refers to a shortest length in the second direction DR2 from the display area AA to the end of the substrate 110a.

For example, a minimum width of a third width W3 of the side surface of the substrate 110a connected to the circuit film 360 may be a width in which the plurality of first pads 101, the plurality of second pads 102, and the plurality of routing lines are disposed. In other words, an area in which the circuit film 360 needs to be disposed on the top surface of the substrate 110a is not required, such that the width W3 of the side surface of the substrate 110a connected to the circuit film 360 may decrease. Therefore, it is possible to decrease the non-display area **NA** or the width of the bezel area of the display device 300.

In addition, the circuit film 360 is disposed below the substrate 110a, and the area, in which the plurality of first via holes 365 disposed in the circuit film 360 are disposed, is decreased, which may decrease an area in which the circuit film 360 protrudes to the outside of the substrate 110a of the display device 300. Therefore, because the circuit film 360 does not need to be bent to decrease an area occupied by the circuit film 360 disposed outside the substrate 110a, it is possible to remove stress caused when the circuit film 360 is bent.

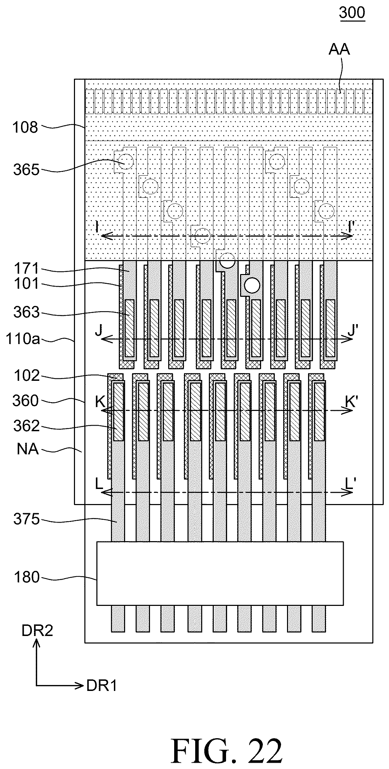

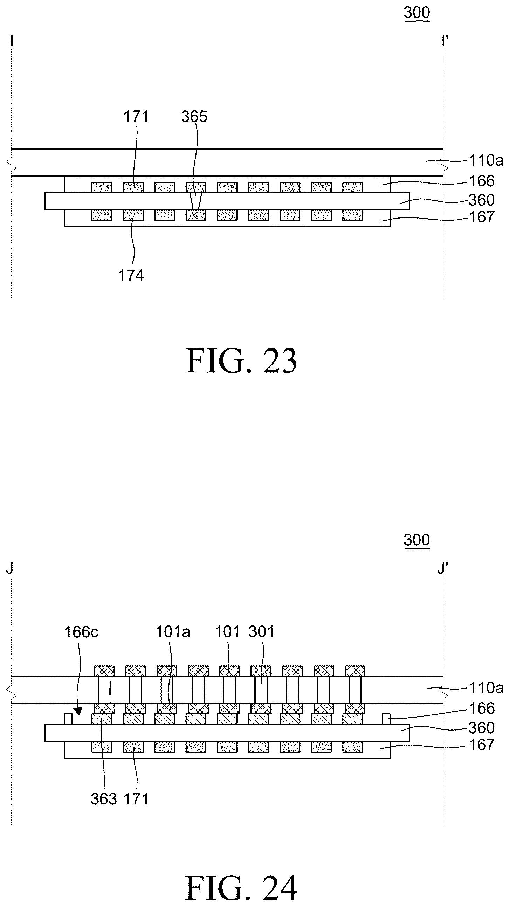

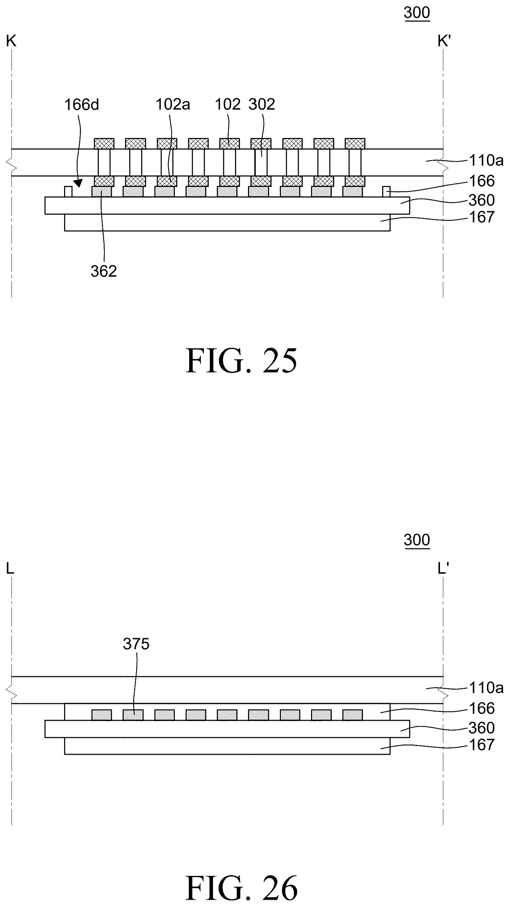

FIG. 22 is a top plan view illustrating a structure in which the substrate and the circuit film of the display device according to still another embodiment of the present specification are connected. FIG. 23 is a cross-sectional view taken along line I-I' in FIG. 22. FIG. 24 is a cross-sectional view taken along line J-J' in FIG. 22. FIG. 25 is a cross-sectional view taken along line K-K' in FIG. 22. FIG. 26 is a cross-sectional view taken along line L-L' in FIG. 22.

With reference to FIGS. 22 to 26, the circuit film 360 may be disposed on a part of the rear surface of the substrate 110a of the display device 300.

The plurality of first signal lines 171 and the plurality of fifth signal lines 375 may be disposed on the top surface of the circuit film 360. The plurality of first signal lines 171 may be respectively connected to the first via holes 365. The plurality of first via holes 365 may be disposed below the substrate 110a of the display device 100.

The plurality of first via holes 365 may electrically connect the first signal lines 171 and the fourth signal lines 174, and the plurality of first signal lines 171, the plurality of fourth signal lines 174, and the plurality of first via holes 365 may at least partially overlap the display area AA.

The display device may further include the plurality of third via holes 301 and the plurality of fourth via holes 302 formed through the substrate 110a in the non-display area **NA** and further include the plurality of first pads 101 disposed on the plurality of third via holes 301 and the substrate 110a, and the plurality of second pads 102 disposed on the plurality of fourth via holes 302 and the substrate 110a. Further, at least one of the plurality of first via holes 365 may overlap the first pad 101.

Specifically, with reference to FIGS. 22 and 23, the circuit film 360 may be disposed below the substrate 110a. The plurality of first signal lines 171 may be disposed on the top surface of the circuit film 360, and the first protective layer 166 disposed on the first signal lines 171 and the circuit film 360 may be disposed on the top surface of the circuit film 360.

The plurality of fourth signal lines 174 may be disposed on the rear surface of the circuit film 360, and the second protective layer 167 disposed on the fourth signal lines 174 and the rear surface of the circuit film 360 may be disposed on the rear surface of the circuit film 360.

At least one first signal line 171 may be electrically connected to one fourth signal line 174 by the first via hole 365 formed through the circuit film 360.

With reference to FIGS. 22 and 24, a plurality of first sub-pads 101a may be respectively connected to the plurality of first pads 101, which are disposed on the substrate 110a, through the plurality of third via holes 301 disposed in the substrate 110a of the display device 300.

Specifically, the first protective layer 166 disposed on the top surface of the circuit film 360 may include third open areas 166c to connect the third via holes 301 and the first sub-pads 101a disposed on the first signal lines 171. The third open areas 166c may overlap the plurality of first sub-pads 101a. That is, a top surface and a side surface of each of the plurality of first sub-pads 101a may not partially overlap the first protective layer 166.

In addition, the third open areas 166c may overlap third connection pads 363 of the plurality of first signal lines 171.

With reference to FIGS. 22 and 25, the plurality of fifth signal lines 375 may be respectively connected to second sub-pads 102a. The second sub-pads 102a may be respectively connected to the plurality of second pads 102, which are disposed on the substrate 110a, through the plurality of fourth via holes 302 disposed in the substrate 110a of the display device 300. The first protective layer 166 disposed on the top surface of the circuit film 360 may include fourth open areas 166d to connect the fourth via holes 302 and the second sub-pads 102a disposed on the fifth signal lines 375.

The fourth open areas 166d may overlap the plurality of second sub-pads 102a. That is, a top surface and a side surface of each of the plurality of second sub-pads 102a may not partially overlap the first protective layer 166. In addition, the fourth open areas 166d may overlap second connection pads 362 of the plurality of fifth signal lines 375.

The plurality of second sub-pads 102a and the second connection pads 362 of the fifth signal lines 375 may be at least partially in contact with the fourth via holes 302 to electrically connect the plurality of second sub-pads 102a and the second connection pads 362 of the plurality of fifth signal lines 375 to the second pads 102.

The fourth open areas 166d of the first protective layer 166 disposed on the top surface of the circuit film 360 of the display device 300 according to still another embodiment of the present specification are disposed to overlap the plurality of second connection pads 362, such that the plurality of second connection pads 362 may be respectively stably connected to the second pads 102 through the fourth via hole 302.

In addition, referring to FIGS. 22 and 26, in at least a part of an area in which the fifth signal lines 375 do not overlap the fourth via holes 302, top surfaces and side surfaces of the fifth signal lines 375 may be surrounded by the first protective layer 166.

In addition, at least a part of the area except for the area in which the second sub-pads 102a are in contact with the fourth via holes 302 may include an area in which the fifth signal lines 375 do not overlap the other signal lines. For example, the fifth signal lines 375 do not overlap the fourth signal lines 174 disposed on the rear surface of the circuit film 360. In this case, the second protective layer 167 may be disposed on the rear surface of the circuit film 360.

FIGS. 22, 24, and 25 illustrate structures in which a part of each of the third connection pads 363 of the plurality of first signal lines 171 overlaps a part of each of the first pads 101, and a part of each of the second connection pads 362 of the plurality of fifth signal lines 175 overlaps a part of each of the second pads 102. However, the present specification is not limited thereto.

As described above, the circuit film 360 is disposed on the rear surface of the substrate 110a, and the plurality of first pads 101 and the plurality of second pads 102 disposed on the top surface of the substrate 110a are electrically connected to the signal lines of the circuit film 360 through the plurality of third via holes 301 and the plurality of fourth via holes 302 disposed in the substrate 110a, such that the circuit film 360 does not need to be connected to the top surface of the substrate 110a in the non-display area NA, which may decrease the size of the non-display area NA.

Because the circuit film 360 of the display device 300 according to still another embodiment of the present specification is electrically connected to the rear surface of the substrate 110a, it is not necessary to consider interference between the circuit film 360 and the cover window 108 disposed on the top surface of the substrate 110a. In other words, a defect caused by interference between the circuit film 360 and the cover window 108 may not occur even though the circuit film 360 is disposed to overlap the cover window 108.

In addition, because the circuit film 360 of the display device 300 is electrically connected on the rear surface of the substrate 110a through the third via holes 301 and the fourth via holes 302 of the substrate 110a, the circuit film 360 of the display device 300 may also overlap the display area AA of the display device 300. In other words, because the circuit film 360 does not need to be disposed only in the non-display area **NA** of the display device 300, a degree of position freedom of the circuit film 360 may be improved.

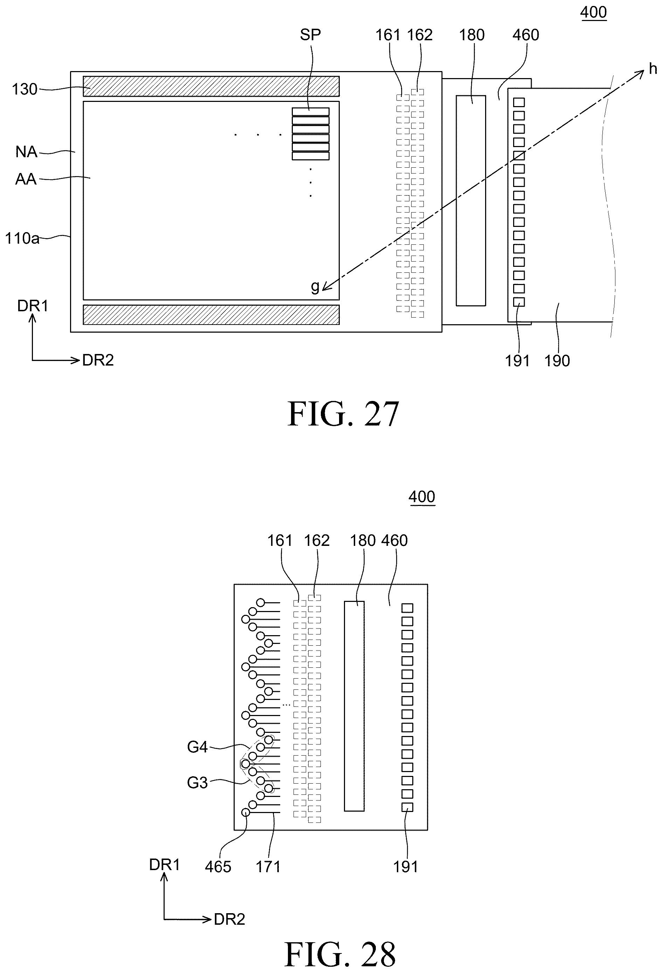

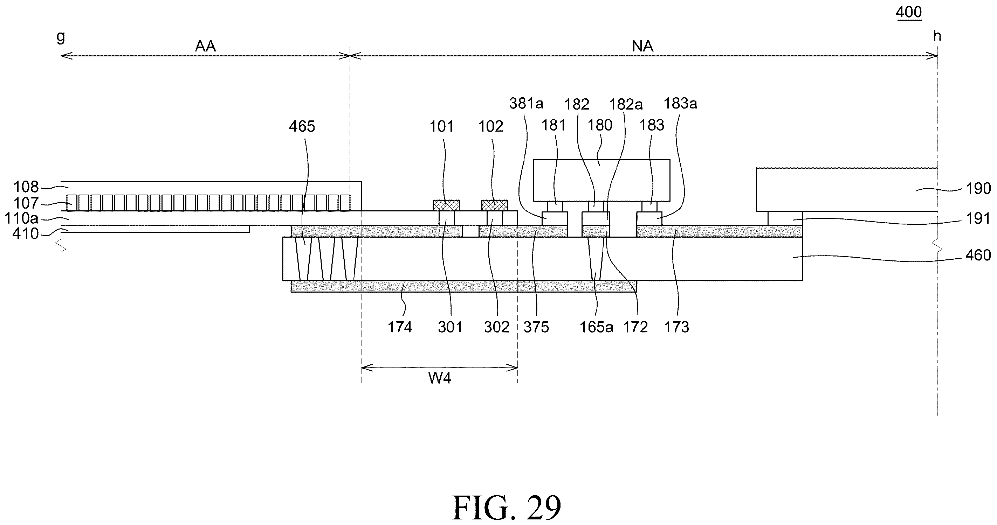

FIG. 27 is a top plan view schematically illustrating a display device according to yet another embodiment of the present specification. FIG. 28 is a top plan view schematically illustrating a circuit film in FIG. 27. FIG. 29 is a view schematically illustrating a cross-sectional structure taken along line g-h in FIG. 27.

A display device 400 in FIGS. 27 to 29 is substantially identical in configuration to the display device 300 in FIGS. 19 to 21, except for an arrangement of the plurality of first via holes 265 and a configuration in which a heat radiation plate 410 is disposed below the substrate 110a. Therefore, repeated descriptions of the identical components will be omitted or may be briefly provided.

With reference to FIGS. 27 to 29, a circuit film 460 may be connected on a part of the rear surface of the non-display area NA of the substrate 110a of the display device 400 through the plurality of third via holes 301 and the plurality of fourth via holes 302, and first via holes 465 disposed in a part of the circuit film 460 may be disposed below the substrate 110a.

The plurality of first via holes 465 may be disposed in the circuit film 460 and grouped into a plurality of groups G3 and G4. For example, the plurality of first via holes 465 may include a third group G3 and a fourth group G4. A plurality of first via holes 465 may be included in each of the third group G3 and the fourth group G4.

The two adjacent third groups G3 and the two adjacent fourth groups G4 may define a 'W' shape in a plan view. The arrangement of the plurality of first via holes 465 in FIGS. 27 to 29 may be substantially identical to the arrangement of the plurality of first via holes 265 included in the display device 200 in FIGS. 11 to 19.

Meanwhile, in case that the display device 400 is a small-scale display device such as a mobile device, the number and area of the circuit film 460 connected to the substrate 110a of the display device 400 also decrease. Therefore, an area for connecting the plurality of signal lines respectively disposed on the top surface and the rear surface of the circuit film 460 may also be narrowed. In the display device 400 according to yet another embodiment of the present specification, the third groups G3 and the fourth groups G4 of the plurality of first via holes 465 disposed in the circuit film 460 are disposed alternately, such that the plurality of first via holes 465 may be efficiently disposed in the circuit film 460.

In addition, because the circuit film 460 is connected on the rear surface of the substrate 110a through the plurality of third via holes 301 and the plurality of fourth via holes 304, the circuit film 460 does not cover the display area AA even though the circuit film 460 overlaps the display area AA.

Therefore, it is possible to decrease a fourth width W4 of the side surface of the substrate 110a connected to the circuit film 460. Therefore, it is possible to decrease the non-display area NA or the width of the bezel area of the display device 400.

The heat radiation plate 410 may be additionally disposed below the substrate 110a.

The heat radiation plate 410 may overlap at least a part of the display area AA and serve to perform control to inhibit heat from affecting the display device 400 even though heat is generated during the operation of the display device. The heat radiation plate 410 may be spaced apart from the circuit film 460 disposed below the substrate 110a.

In particular, the third groups G3 and the fourth groups G4 of the plurality of first via holes 465 disposed in the circuit film 460 are disposed alternately, such that the area in which the plurality of first via holes 465 are disposed may decrease, which may suppress the occurrence of interference with the heat radiation plate 410 disposed to overlap at least a part of the display area AA. Therefore, it is possible to suppress the occurrence of a defect of the display device 400 caused by interference between the circuit film 460 and the heat radiation plate 410. In addition, the circuit film 460 is disposed below the substrate 110a, and the area, in which the plurality of first via holes 465 disposed in the circuit film 460 are disposed, is decreased, which may decrease an area in which the circuit film 460 protrudes to the outside of the substrate 110a of the display device 400. Therefore, because the circuit film 460 does not need to be bent to decrease an area occupied by the circuit film 460 disposed outside the substrate 110a, it is possible to remove stress caused when the circuit film 460 is bent.

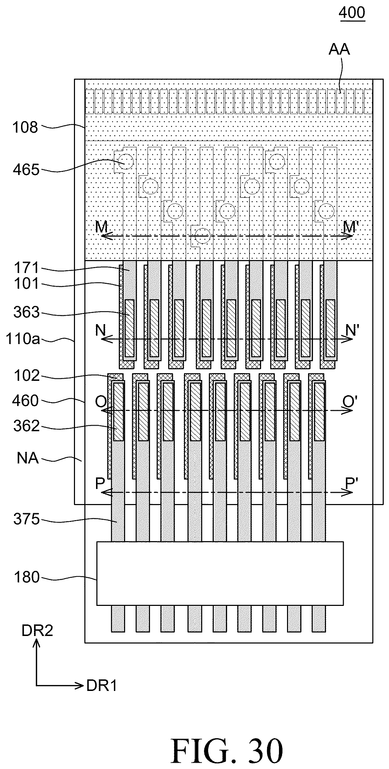

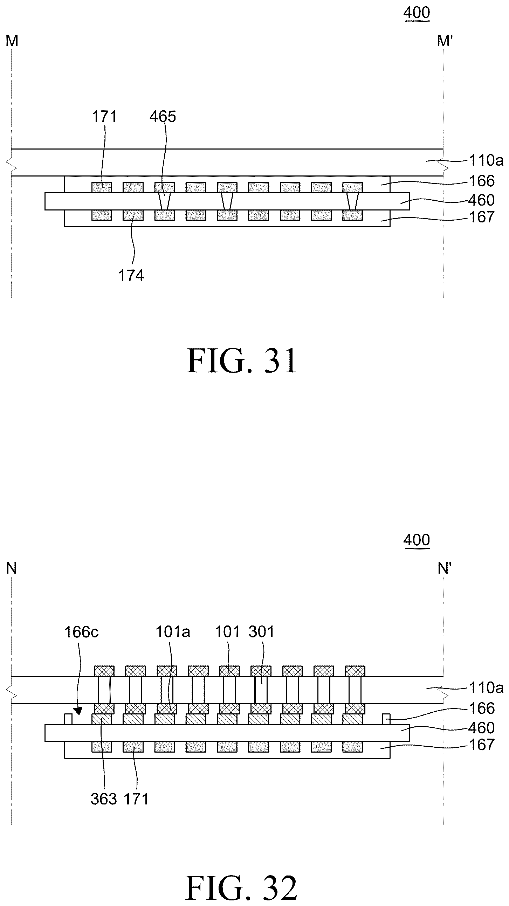

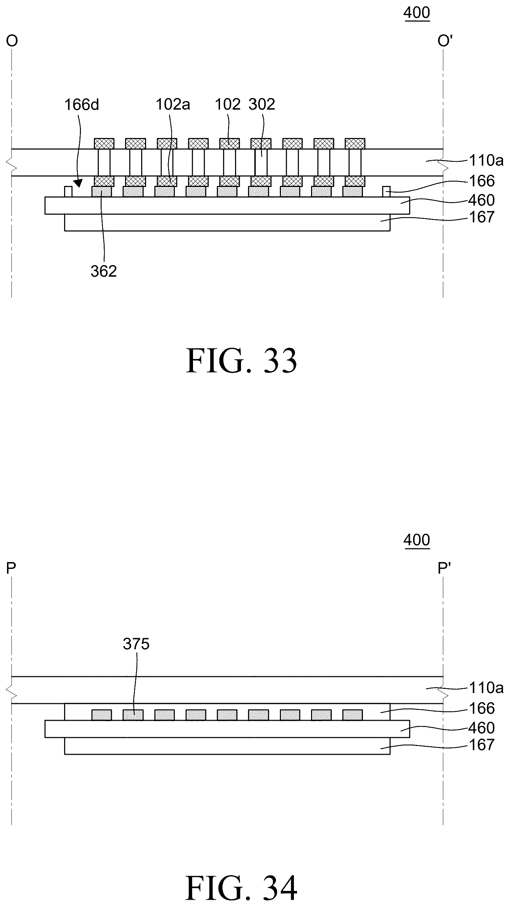

FIG. 30 is a top plan view illustrating a structure in which the substrate and the circuit film of the display device according to yet another embodiment of the present specification are connected. FIG. 31 is a cross-sectional view taken along line M-M' in FIG. 30. FIG. 32 is a cross-sectional view taken along line N-N' in FIG. 30. FIG. 33 is a cross-sectional view taken along line O-O' in FIG. 30. FIG. 34 is a cross-sectional view taken along line P-P' in FIG. 30.

The display device 400 in FIGS. 30 to 34 is substantially identical in configuration to the display device 300 in FIGS. 22 to 26, except for the arrangement of the plurality of first via holes 465. Therefore, repeated descriptions of the identical components will be omitted or may be briefly provided.

With reference to FIGS. 30 to 34, the plurality of first via holes 465 of the display device 400 may be disposed below the substrate 110a of the display device 400.

The plurality of first via holes 465 is arranged in a plurality of 'W' shapes in a plan view, such that the number of first via holes 465 disposed in the circuit film 460 per unit area may increase. Therefore, the plurality of first via holes 465 may be efficiently disposed even though the size of the display device 400 and the size of the circuit film 460 are decreased.

In addition, because the circuit film 460 of the display device 400 is electrically connected on the rear surface of the substrate 110a through the third via holes 301 and the fourth via holes 302 of the substrate 110a, the circuit film 460 of the display device 400 may also overlap the display area AA of the display device 400. In other words, because the circuit film 460 does not need to be disposed only in the non-display area **NA** of the display device 400, a degree of position freedom of the circuit film 460 may be improved.

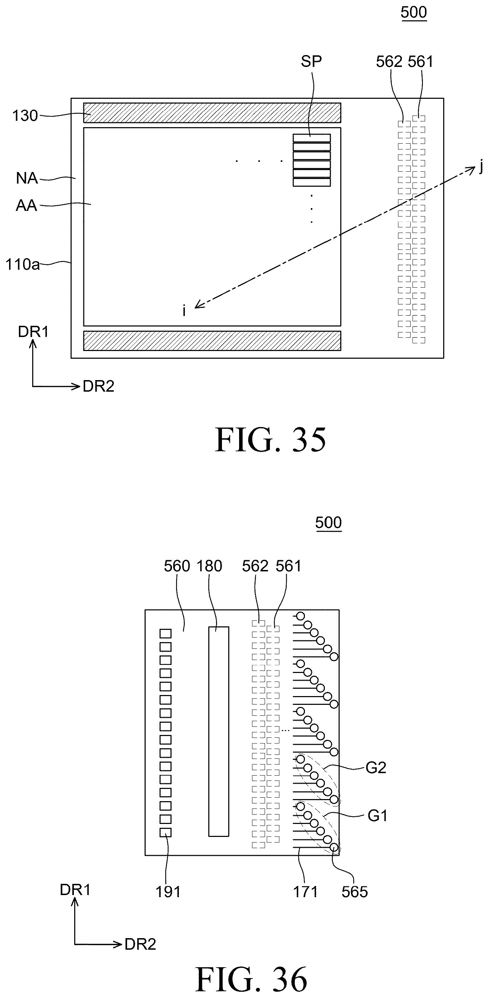

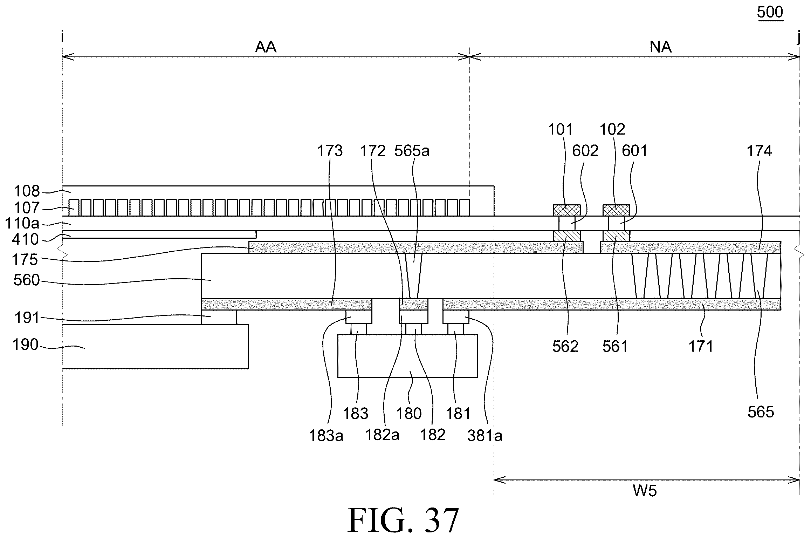

FIG. 35 is a top plan view schematically illustrating a display device according to still yet another embodiment of the present specification. FIG. 36 is a top plan view schematically illustrating a circuit film in FIG. 35. FIG. 37 is a view schematically illustrating a cross-sectional structure taken along line i-j in FIG. 35.

A display device 500 in FIGS. 36 to 38 is substantially identical in configuration to the display device 100 described with reference to FIGS. 2 to 5, except that a circuit film 560 is electrically connected to the rear surface of the substrate 110a, and the circuit film 560 has a structure disposed below the substrate 110a and inverted upside down. Therefore, repeated descriptions of the identical components will be omitted or may be briefly provided.

With reference to FIGS. 35 to 37, the display device 500 may include the display panel 110 and the circuit film 560.

The circuit film 560 may be connected to a part of the rear surface of the non-display area NA **of** the substrate 110a of the display device 500.

The entire circuit film 560 disposed below the substrate 110a may overlap the substrate 110a. Therefore, in a plan view, the circuit film 560 may not be visible by being covered by the substrate 110a.

In addition, in the case of a structure in which the source driver integrated circuit 180 is mounted on the circuit film 560 of the display device 500 according to still yet another embodiment of the present specification and the printed circuit 190 is connected to one side of the circuit film 560, the printed circuit 190 connected to the circuit film 560 may also be disposed below the substrate 110a, and the entire printed circuit 190 may overlap the substrate 110a.

The printed circuit 190 and the source driver integrated circuit 180 mounted on the circuit film 560 may overlap the display area AA. However, the present specification is not limited thereto. The circuit film 560 may be a printed circuit board on which the timing controller 140 is mounted.

The plurality of fourth signal lines 174 and the plurality of fifth signal lines 175 may be disposed on the top surface of the circuit film 560. The plurality of first signal lines 171, the plurality of second signal lines 172, the plurality of third signal lines 173, and the source driver integrated circuit 180 may be disposed on the rear surface of the circuit film 560.

The plurality of first signal lines 171 may be respectively electrically connected to the plurality of fourth signal lines 174 through a plurality of first via holes 565 provided in the circuit film 560.

The plurality of first via holes 565 may be disposed in the circuit film 560 and grouped into a plurality of groups G1 and G2. For example, the plurality of first via holes 565 may include the first group G1 and the second group G2, and the first group G1 and the second group G2 may be arranged while having the same regularity as the arrangement of the plurality of first via holes 165 described with reference to FIGS. 2 to 5.

The plurality of first via holes 565 may overlap the non-display area NA of the substrate 110a. In addition, the plurality of second signal lines 172 disposed on the rear surface of the circuit film 560 may be electrically connected to the fifth signal lines 175, which are disposed on the top surface of the circuit film 160, through second via holes 565a disposed in the circuit film 160.

At least some of the second via holes 565a may be disposed to overlap the display area AA.

The plurality of fourth signal lines 174 disposed on the top surface of the circuit film 560 may be respectively electrically connected to the plurality of second pads 102, which are disposed on the substrate 110a, through the plurality of third via holes 601 disposed in the substrate 110a.

In addition, the plurality of fifth signal lines 175 disposed on the top surface of the circuit film 560 may be respectively electrically connected to the plurality of first pads 101, which are disposed on the substrate 110a, through the plurality of fourth via holes 602 disposed in the substrate 110a. Specifically, a first connection pad 561 may be disposed on a part of the top surface of each of the plurality of fourth signal lines 174.

The plurality of first connection pads 561 may be in contact with the plurality of third via holes 601 provided in the non-display area NA of the substrate 110a. Further, the plurality of third via holes 601 may be respectively in contact with the plurality of second pads 102 disposed in the non-display area NA of the substrate 110a. In addition, a second connection pad 562 may be disposed on a part of the top surface of each of the plurality of fifth signal lines 175.

The plurality of second connection pads 561 may be in contact with the plurality of fourth via holes 602 provided in the non-display area NA of the substrate 110a. Further, the plurality of fourth via holes 602 may be respectively in contact with the plurality of first pads 101 disposed in the non-display area NA of the substrate 110a.

That is, the display device may further include the plurality of first pads 101 and the plurality of second pads 102 disposed on the substrate 110a in the non-display area NA and further include the source driver integrated circuit 180 mounted on the circuit film 560. Some of the plurality of first signal lines 171 and some of the plurality of second signal lines 172 may be electrically connected to the source driver integrated circuit 180, the fourth signal lines 174 may be connected to the second pads 102, and the fifth signal lines 175 may be connected to the first pads 101.

At least one second connection pad 562 and at least one first pad 101 may each be disposed to be closer to the display area AA than each of at least one first connection pad 561 and at least one second pad 102 to the display area AA. For example, at least one first pad 101 may be disposed to be closer to the display area AA than at least one second pad 102 to the display area AA.

The plurality of first via holes 565 may be disposed to be farther from the display area AA than the plurality of third via holes 601 and the plurality of fourth via holes 602 provided in the substrate 110a.

In addition, the plurality of third via holes 601 and the plurality of fourth via holes 602 may be disposed between the plurality of first via holes 565 and the plurality of second via holes 565a. At least some of the plurality of second via holes 565a may overlap the display area AA.

In addition, at least some of the first signal lines 171, at least some of the second signal lines 172, and at least some of the fifth signal lines 175 may be disposed to overlap the display area AA.

In addition, the plurality of third via holes 601 and the plurality of fourth via holes 602 may be disposed between the plurality of first via holes 565 and the cover window 108.

Because the circuit film 560 of the display device 500 according to still yet another embodiment of the present specification is electrically connected on the rear surface of the substrate 110a through the plurality of third via holes 601 and the plurality of fourth via holes 602, a defect caused by interference between the circuit film 560 and the cover window 108 may not occur even though the circuit film 560 is disposed to overlap the cover window 108.

In addition, because the circuit film 560 is connected on the rear surface of the substrate 110a through the plurality of third via holes 601 and the plurality of fourth via holes 602, the circuit film 560 does not cover the display area AA even though the circuit film 560 overlaps the display area AA.

In particular, because the entire circuit film 560 is disposed to overlap the substrate 110a, the non-display area NA of the substrate 110a only requires an area in which the plurality of first pads 101 and the plurality of second pads 102 are disposed and the plurality of routing lines electrically connected to the plurality of first pads 101 and the plurality of second pads 102 are disposed.

Therefore, it is possible to decrease a width of the side surface of the substrate 110a connected to the circuit film 560. In this case, the width of the side surface of the substrate 110a connected to the circuit film 560 refers to a shortest length in the second direction DR2 from the display area AA to the end of the substrate 110a. In other words, an area in which the circuit film 560 needs to be disposed on the top surface of the substrate 110a is not required, such that a fifth width W5 of the side surface of the substrate 110a connected to the circuit film 560 may decrease.

Furthermore, because the entire circuit film 560 is disposed to overlap the substrate 110a, an area excluding the display area AA and the non-display area NA of the display panel 110 is not required. Therefore, the display device 100 may be formed concisely.

In addition, the circuit film 560 is disposed below the substrate 110a, and the area, in which the plurality of first via holes 565 disposed in the circuit film 560 are disposed, is decreased, which may decrease an area in which the circuit film 560 protrudes to the outside of the substrate 110a of the display device 500. Therefore, because the circuit film 560 does not need to be bent to decrease an area occupied by the circuit film 560 disposed outside the substrate 110a, it is possible to remove stress caused when the circuit film 560 is bent.

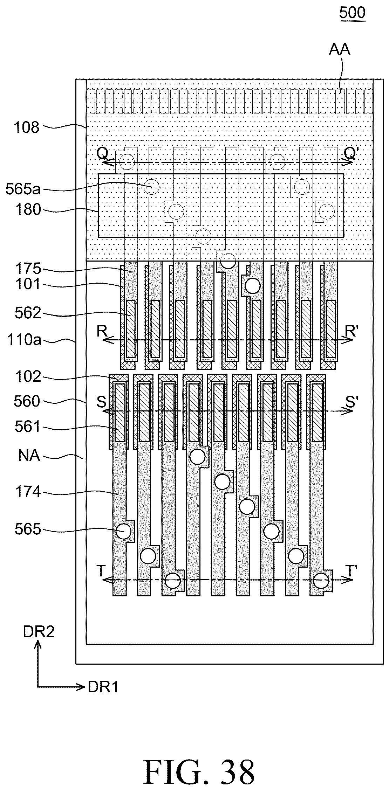

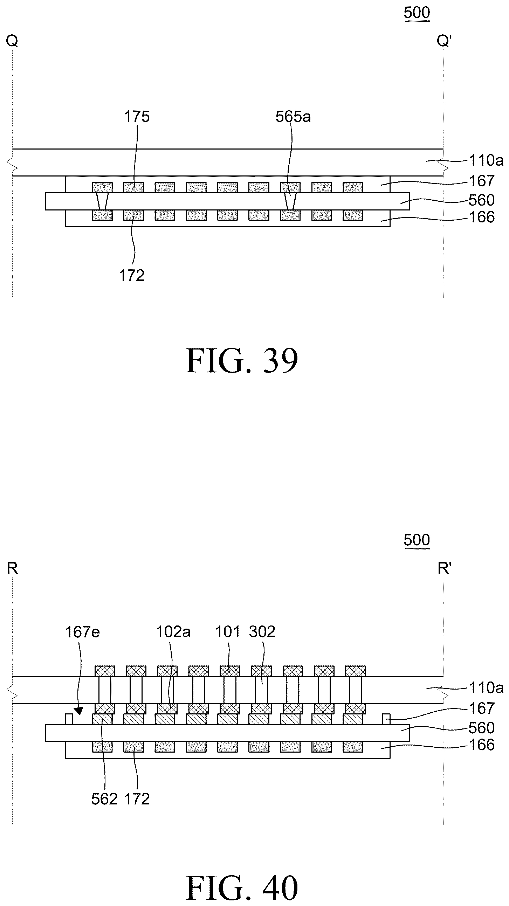

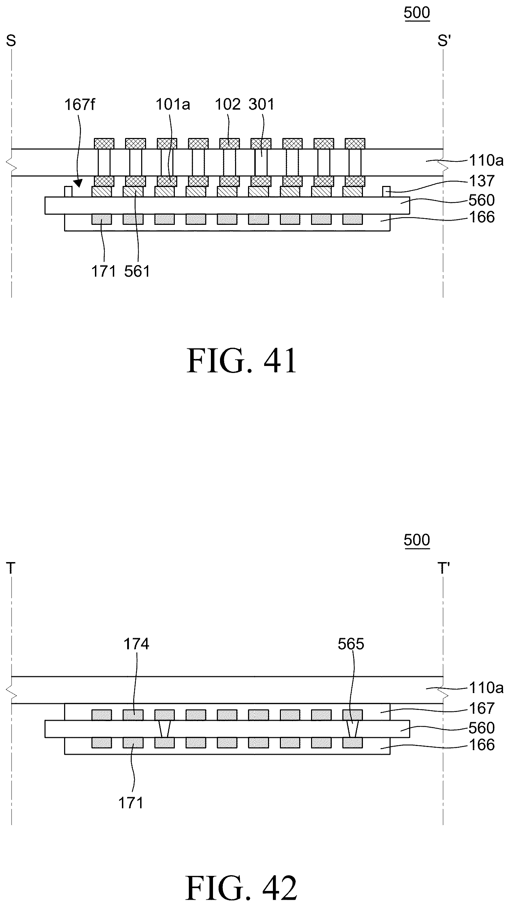

FIG. 38 is a top plan view illustrating a structure in which the substrate and the circuit film of the display device according to still yet another embodiment of the present specification are connected. FIG. 39 is a cross-sectional view taken along line Q-Q' in FIG. 38. FIG. 40 is a cross-sectional view taken along line R-R' in FIG. 38. FIG. 41 is a cross-sectional view taken along line S-S' in FIG. 38. FIG. 42 is a cross-sectional view taken along line T-T' in FIG. 38.

The display device 500 in FIGS. 38 to 42 is substantially identical in configuration to the display device 100 in FIGS. 6 to 10, except that the circuit film 560 is electrically connected to the rear surface of the substrate 110a, the circuit film 560 has the structure disposed below the substrate 110a and inverted upside down, and the plurality of second via holes 565a are differently arranged. Therefore, repeated descriptions of the identical components will be omitted.

With reference to FIGS. 38 to 42, the substrate 110a and the circuit film 560 of the display device 500 may entirely overlap.

The plurality of fourth signal lines 174, the plurality of fifth signal lines 175, the plurality of first connection pads 561, the plurality of second connection pads 562, and the second protective layer 167 may be disposed on the top surface of the circuit film 560. The plurality of first signal lines 171, the plurality of second signal lines 172, and the first protective layer 166 may be disposed on the rear surface of the circuit film 560.

In addition, the plurality of first via holes 565 and the plurality of second via holes 565a may be disposed in the circuit film 560.

The plurality of fourth signal lines 174 may be positioned to be farther from the display area AA than the plurality of fifth signal lines 175 from the display area AA. For example, the plurality of fourth signal lines 174 may overlap the non-display area NA. At least some of the plurality of fifth signal lines 175 may overlap the display area AA, and some of the remaining fifth signal lines 175 may overlap the non-display area NA.

The plurality of fifth signal lines 175 may be respectively connected to the second via holes 565a. At least one of the plurality of second via holes 565a may overlap the first pad 101. Further, at least one of the plurality of first via holes 565 may overlap the second pad 102.

The plurality of second via holes 565a, which serves to connect the plurality of fifth signal lines 175 to the plurality of second signal lines 172, are disposed in the circuit film 560, such that the plurality of second via holes 565a may overlap the plurality of components, and a limited area of the circuit film 560 may be efficiently utilized.

In addition, the plurality of fourth signal lines 174 may be respectively connected to the first via holes 565. At least one of the plurality of first via holes 565 may overlap the second pad 102. The plurality of first via holes 565, which serves to connect the plurality of fourth signal lines 174 to the plurality of first signal lines 171, is disposed in the circuit film 560, such that the plurality of first via holes 565 may overlap the plurality of components, and the limited area of the circuit film 560 may be more efficiently utilized.

Furthermore, at least some of the plurality of fifth signal lines 175 and at least some of the plurality of second via holes 565a may also overlap the source driver integrated circuit 180.

With reference to FIGS. 38 and 39, the circuit film 560 may be disposed below the substrate 110a. The second signal lines 172 and the fifth signal lines 175 may be electrically connected through the second via holes 565a formed through the circuit film 560.

In addition, at least one second signal line 172, at least one fifth signal line 175, and at least one second via hole 565a may overlap the display area AA.

With reference to FIGS. 38 and 40, the plurality of fifth signal lines 175 may be respectively connected to the second sub-pads 102a. The plurality second sub-pads 102a may be respectively connected to the plurality of first pads 101, which are disposed on the substrate 110a, through the plurality of fourth via holes 602 disposed in the substrate 110a of the display device 500.

Specifically, the second protective layer 167 disposed on the top surface of the circuit film 560 may include fifth open areas 167e to connect the fourth via holes 602 and the second sub-pads 102a disposed on the fifth signal lines 175. The fifth open areas 167e may overlap the plurality of second sub-pads 102a.

In addition, the fifth open areas 167e may overlap the second connection pads 562 of the plurality of fifth signal lines 175.

With reference to FIGS. 38 and 41, the plurality of fourth signal lines 174 may be respectively connected to the first sub-pads 101a. The first sub-pads 101a may be respectively connected to the plurality of second pads 102, which are disposed on the substrate 110a, through the plurality of third via holes 601 disposed in the substrate 110a of the display device 500.

Specifically, the second protective layer 167 disposed on the top surface of the circuit film 560 may include sixth open areas 167f to connect the third via holes 601 and the first sub-pads 101a disposed on the fourth signal lines 174.

The sixth open areas 167f may overlap the plurality of first sub-pads 101a. That is, a top surface and a side surface of each of the plurality of first sub-pads 101a may not partially overlap the second protective layer 167. In addition, the sixth open areas 167f may overlap the first connection pads 561 of the plurality of fourth signal lines 174. That is, a top surface and a side surface of each of the first connection pads 561 of the plurality of fourth signal lines 174 may not partially overlap the second protective layer 167.

The sixth open areas 167f of the second protective layer 167 disposed on the top surface of the circuit film 560 of the display device 500 according to still yet another embodiment of the present specification are disposed to overlap the plurality of first connection pads 561, such that the plurality of first connection pads 561 may be respectively stably connected to the second pads 102 through the third via holes 601.

At least a part of the area in which the first connection pads 561 are in contact with the third via holes 601 may include an area in which the fourth signal lines 174 and the other signal lines do not overlap. In an area in which the first connection pads 561 and the first signal lines 171, which are disposed on the rear surface of the circuit film 560, do not overlap, the first protective layer 166 may be disposed on the rear surface of the circuit film 560.

In addition, with reference to FIGS. 38 and 42, in at least a part of an area in which the fourth signal lines 174 do not overlap the third via holes 601, top surfaces and side surfaces of the fourth signal lines 174 may be surrounded by the second protective layer 167.

In addition, at least a part of the area except for the area in which the first sub-pads 101a are in contact with the third via holes 301 may include an area in which the fourth signal lines 174 do not overlap the other signal lines. For example, the fourth signal lines 174 do not overlap the first signal lines 171 disposed on the rear surface of the circuit film 560. In this case, the first protective layer 166 may be disposed on the rear surface of the circuit film 560.

As described above, the circuit film 560 is disposed on the rear surface of the substrate 110a, and the plurality of first pads 101 and the plurality of second pads 102 disposed on the top surface of the substrate 110a are electrically connected to the signal lines of the circuit film 560 through the plurality of third via holes 601 and the plurality of fourth via holes 602 disposed in the substrate 110a, such that the circuit film 560 does not need to be connected to the top surface of the substrate 110a in the non-display area NA, which may decrease the size of the non-display area NA.

In addition, because the circuit film 560 of the display device 500 is electrically connected on the rear surface of the substrate 110a through the third via holes 601 and the fourth via holes 602 of the substrate 110a, the circuit film 560 of the display device 500 may also overlap the display area AA of the display device 500, such that the degree of position freedom of the circuit film 560 may be improved.

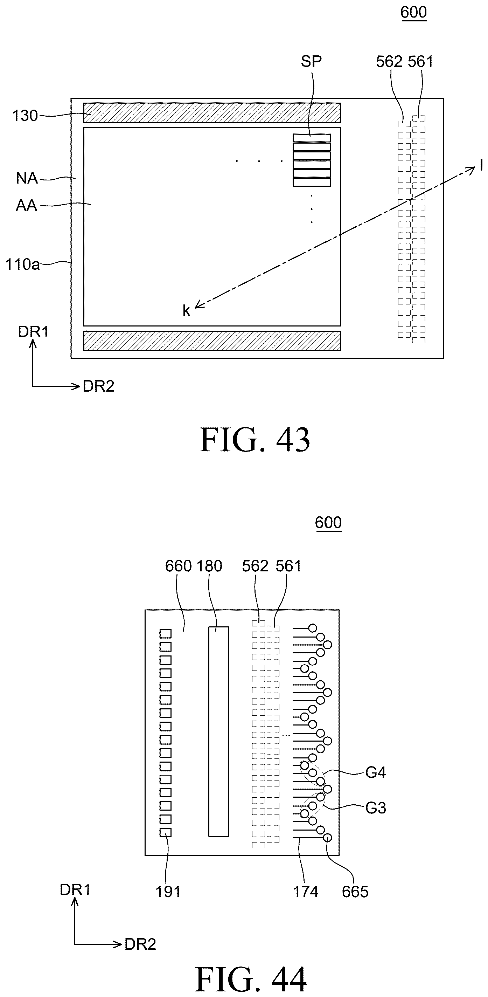

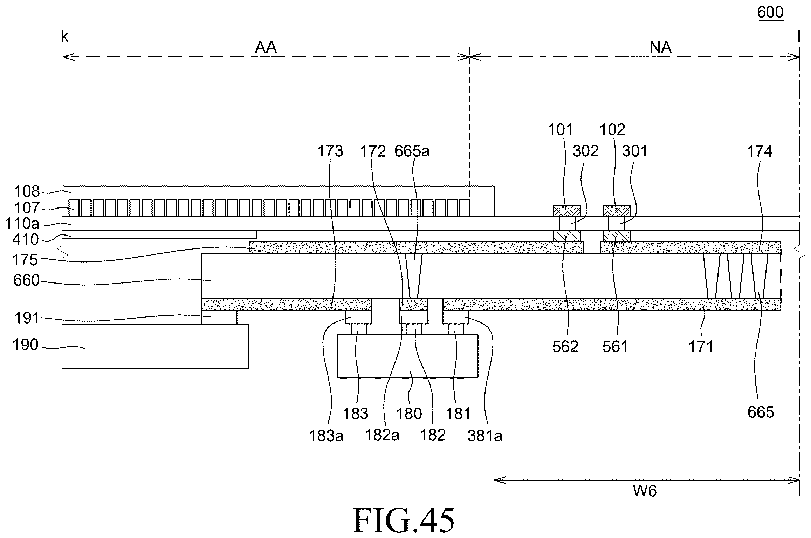

FIG. 43 is a top plan view schematically illustrating a display device according to a further embodiment of the present specification. FIG. 44 is a top plan view schematically illustrating a circuit film in FIG. 43. FIG. 45 is a view schematically illustrating a cross-sectional structure taken along line k-l in FIG. 43.

A display device 600 in FIGS. 43 to 45 is substantially identical in configuration to the display device 500 in FIGS. 35 to 37, except for an arrangement of a plurality of first via holes 665 and an arrangement of a plurality of second via holes 665a. Therefore, repeated descriptions of the identical components will be omitted or may be briefly provided.

With reference to FIGS. 43 to 45, a circuit film 660 may be connected on a part of the rear surface of the non-display area NA of the substrate 110a of the display device 600 through the plurality of third via holes 301 and the plurality of fourth via holes 302, and first via holes 665 disposed in a part of the circuit film 660 may be disposed below the substrate 110a.

The plurality of first via holes 665 may be disposed in the circuit film 660 and grouped into a plurality of groups G3 and G4. For example, the plurality of first via holes 665 may include a third group G3 and a fourth group G4.

The arrangement of the plurality of first via holes 665 included in the third group G3 and the fourth group G4 may be identical to the arrangement of the plurality of first via holes 465 described with reference to FIGS. 27 to 29.

Because the circuit film 660 is connected on the rear surface of the substrate 110a through the plurality of third via holes 301 and the plurality of fourth via holes 304, the circuit film 660 does not cover the display area AA even though the circuit film 660 overlaps the display area AA.

Therefore, it is possible to decrease a sixth width W6 of the side surface of the substrate 110a connected to the circuit film 660. Therefore, it is possible to decrease the non-display area NA or the width of the bezel area of the display device 600.

The plurality of second via holes 665a formed through the circuit film 660 may also be arranged in the same way as the plurality of first via holes 665. Therefore, the plurality of second via holes 665a may also be efficiently disposed in the circuit film 660 having a limited area without using a large area.

In addition, the circuit film 660 is disposed below the substrate 110a, and the area, in which the plurality of first via holes 665 and the plurality of second via holes 665a disposed in the circuit film 660 are disposed, is decreased, which may decrease an area in which the circuit film 660 protrudes to the outside of the substrate 110a of the display device 600. Therefore, because the circuit film 660 does not need to be bent to decrease an area occupied by the circuit film 660 disposed outside the substrate 110a, it is possible to remove stress caused when the circuit film 660 is bent.

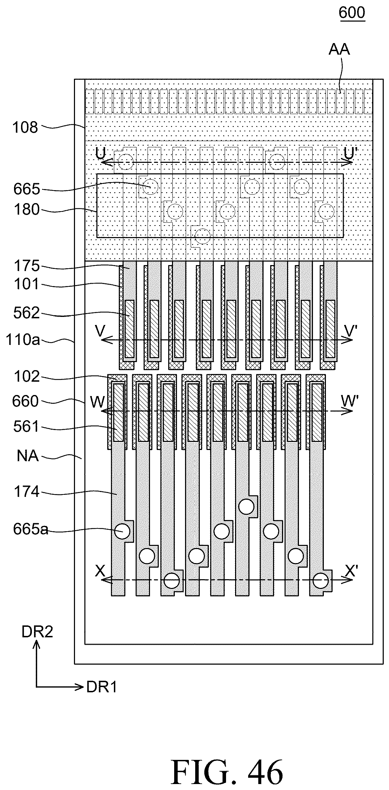

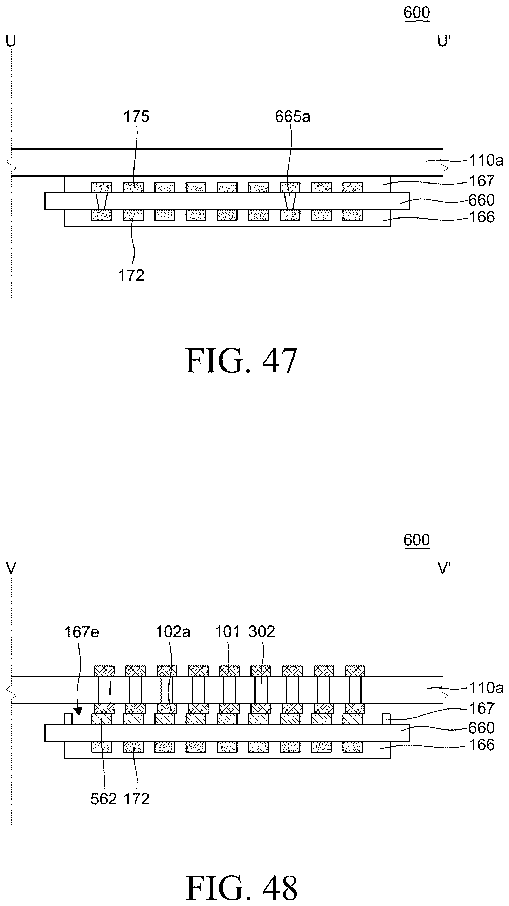

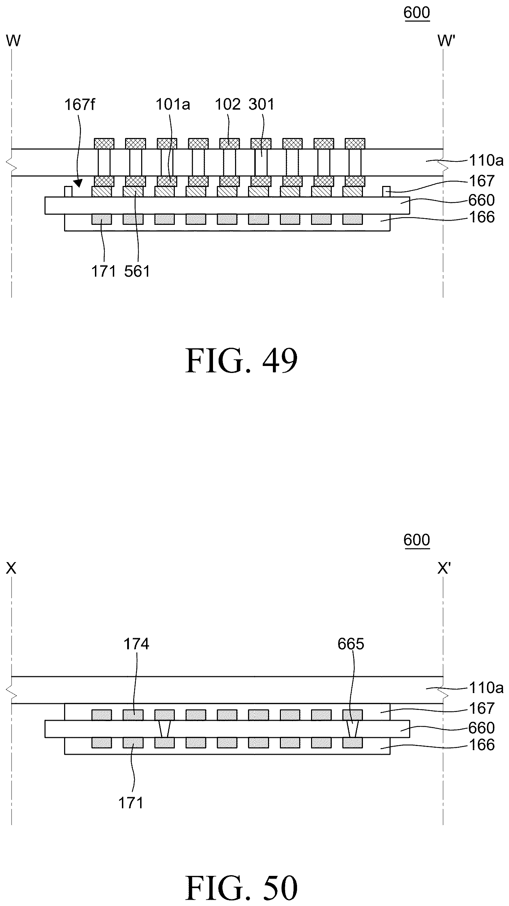

FIG. 46 is a top plan view illustrating a structure in which the substrate and the circuit film of the display device according to the further embodiment of the present specification are connected. FIG. 47 is a cross-sectional view taken along line U-U' in FIG. 46. FIG. 48 is a cross-sectional view taken along line V-V' in FIG. 46. FIG. 49 is a cross-sectional view taken along line W-W' in FIG. 46. FIG. 50 is a cross-sectional view taken along line X-X' in FIG. 46.

The display device 600 in FIGS. 46 to 50 is substantially identical in configuration to the display device 500 in FIGS. 38 to 42, except for the arrangement of the plurality of first via holes 665 and the arrangement of the plurality of second via holes 665a. Therefore, repeated descriptions of the identical components will be omitted or may be briefly provided.

With reference to FIGS. 46 to 50, the circuit film 660 may be connected on a part of the rear surface of the substrate 110a of the display device 600 through the plurality of third via holes 301 and the plurality of fourth via holes 302 provided in the substrate 110a.

The plurality of first via holes 665 are arranged in a plurality of 'W' shapes in a plan view, such that the number of first via holes 665 disposed in the circuit film 660 per unit display area may increase. Therefore, the plurality of first via holes 665 may be efficiently disposed even though the size of the display device 600 and the size of the circuit film 660 are decreased.

In addition, the plurality of fifth signal lines 175, which are disposed on the top surface of the circuit film 660, and the plurality of second signal lines 172, which are disposed on the rear surface of the circuit film 660, may be electrically connected through second via holes 665a.

The plurality of second via holes 665a may be disposed below the substrate 110a of the display device 600. The plurality of second via holes 665a are arranged in a plurality of 'W' shapes in a plan view, such that the number of second via holes 665a disposed in the circuit film 660 per unit area may increase. Therefore, the plurality of second via holes 665a may be efficiently disposed even though the size of the display device 600 and the size of the circuit film 660 are decreased.

The exemplary embodiments of the present disclosure can also be described as follows:

According to an aspect of the present disclosure, there is provided a display device. The display device includes a substrate comprising a display area and a non-display area and a circuit film electrically connected to at least one side in the non-display area of the substrate. The circuit film includes a plurality of first via holes configured to overlap the non-display area and formed through the circuit film. Some of the plurality of first via holes are included in a first group. Some of the remaining first via holes are included in a second group. The plurality of first via holes included in the first and second groups are arranged in a direction between a first direction and a second direction that is a direction intersecting the first direction. The first and second groups are disposed alternately in the first direction. Alignment directions of the plurality of first via holes included in the first group are identical to one another. Alignment directions of the plurality of first via holes included in the second group are identical to one another.

The circuit film may be disposed on the substrate. The circuit film further may include a plurality of first signal lines, a plurality of second signal lines, and a plurality of third signal lines disposed on a top surface of the circuit film. The circuit film may include a plurality of fourth signal lines and a plurality of fifth signal lines disposed on a rear surface of the circuit film, and The first via holes electrically may connect the first signal lines and the fourth signal lines.

The circuit film may include a plurality of second via holes configured to electrically connect the second signal lines and the fifth signal lines and formed through the circuit film. The second via hole may be disposed in the non-display area and disposed to be farther from the display area than the first via hole from the display area.

The display device may include a plurality of first pads and a plurality of second pads disposed on the substrate in the non-display area and an integrated circuit mounted on the circuit film. Some of the first signal lines and some of the second signal lines may be electrically connected to the integrated circuit, The fourth signal line may be connected to the first pad. The fifth signal line may be connected to the second pad.

At least one of the plurality of first pads may be disposed to be closer to the display area than at least one of the plurality of second pads to the display area.

The circuit film may be disposed below the substrate.

The display device may include a cover window disposed on the substrate and disposed in the entire display area and a part of the non-display area. A part of the circuit film may overlap a part of the cover window.

The circuit film may include a plurality of first signal lines, a plurality of second signal lines, a plurality of third signal lines, and a plurality of fifth signal lines disposed on a top surface of the circuit film. The circuit film may include a plurality of fourth signal lines disposed on a rear surface of the circuit film. The first via holes electrically connect the first signal lines and the fourth signal lines. At least some of the plurality of first signal lines, at least some of the plurality of fourth signal lines, and at least some of the plurality of first via holes may overlap the display area.

The display device may include a plurality of third via holes and a plurality of fourth via holes formed through the substrate in the non-display area, a plurality of first pads disposed on the plurality of third via holes and the substrate and a plurality of second pads disposed on the plurality of fourth via holes and the substrate. At least one of the plurality of first via holes may overlap the first pad.

The display device may include an integrated circuit mounted on the circuit film. The first signal line may be electrically connected to the third via hole. The fifth signal line may be electrically connected to the fourth via hole. The fifth signal line may be electrically connected to the integrated circuit. Each of the plurality of third via holes and the plurality of fourth via holes may be positioned to be farther from the display area than each of the plurality of first via holes from the display area.

The display device may include a heat radiation plate disposed below the substrate and configured to overlap at least a part of the display area. The circuit film may be spaced apart from the heat radiation plate.

The entire circuit film may overlap the substrate.

The circuit film may include a plurality of first signal lines, a plurality of second signal lines, and a plurality of third signal lines disposed on a rear surface of the circuit film, a plurality of fourth signal lines and a plurality of fifth signal lines disposed on a top surface of the circuit film and a plurality of second via holes configured to electrically connect the second signal lines and the fifth signal lines and formed through the circuit film. The first via hole electrically may connect the first signal line and the fourth signal line. At least some of the plurality of second via holes may overlap the display area.

The first signal line, the second signal line, and the fifth signal line at least partially may overlap the display area.

The display device may include a plurality of first pads and a plurality of second pads disposed on the substrate in the non-display area and an integrated circuit mounted on the circuit film. A part of each of the first signal line and the second signal line may be electrically connected to the integrated circuit. The fourth signal line may be connected to the second pad. The fifth signal line may be connected to the first pad. At least one of the plurality of first via holes may overlap the second pad.

At least one of the plurality of first pads may be disposed to be closer to the display area than at least one of the plurality of second pads to the display area.

The display device may include a plurality of third via holes and a plurality of fourth via holes formed through the substrate in the non-display area. The plurality of first via holes may be disposed to be farther from the display area than the plurality of third via holes and the plurality of fourth via holes from the display area.

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure. The protective scope of the present disclosure should be construed based on the following claims, and all the technical concepts in the equivalent scope of the present disclosure thereof should be construed as falling within the scope of the present disclosure.

## Claims

1. A display device comprising:
a substrate comprising a display area and a non-display area; and
a circuit film electrically connected to at least one side in the non-display area of the substrate,
wherein the circuit film comprises a plurality of first via holes configured to overlap the non-display area and formed through the circuit film,
wherein some of the plurality of first via holes are included in a first group,
wherein some of the remaining first via holes are included in a second group,
wherein the plurality of first via holes included in the first and second groups are arranged in a direction between a first direction and a second direction that is a direction perpendicular to the first direction,
wherein the first and second groups are disposed alternately in the first direction,
wherein alignment directions of the plurality of first via holes included in the first group are identical to one another, and
wherein alignment directions of the plurality of first via holes included in the second group are identical to one another.

2. The display device of claim 1, wherein the circuit film is disposed on the substrate,
wherein the circuit film further comprises a plurality of first signal lines, a plurality of second signal lines, and a plurality of third signal lines disposed on a first surface of the circuit film,
wherein the circuit film further comprises a plurality of fourth signal lines and a plurality of fifth signal lines disposed on a second surface of the circuit film,
wherein the first via holes electrically connect the first signal lines and the fourth signal lines, and
wherein the first direction is perpendicular to a direction in which one of the first signal lines extends.

3. The display device of claim 2, wherein the circuit film further comprises a plurality of second via holes configured to electrically connect the second signal lines and the fifth signal lines and formed through the circuit film, and
wherein at least one of the plurality of second via holes is disposed in the non-display area and disposed to be farther from the display area than at least one of the plurality of first via holes from the display area.

4. The display device of claim 2 or claim 3, further comprising:
a plurality of first pads and a plurality of second pads disposed on the substrate in the non-display area; and
an integrated circuit mounted on the circuit film,
wherein some of the first signal lines and some of the second signal lines are electrically connected to the integrated circuit,
wherein one of the fourth signal lines is connected to one of the plurality of first pads, and
wherein one of the fifth signal lines is connected to one of the plurality of second pads; and optionally:
wherein at least one of the plurality of first pads is disposed to be closer to the display area than at least one of the plurality of second pads to the display area.

5. The display device of any preceding claim, wherein the circuit film is disposed below the substrate.

6. The display device of claim 5, further comprising:
a cover window disposed on the substrate and disposed in the entire display area and a part of the non-display area,
wherein a part of the circuit film overlaps a part of the cover window.

7. The display device of claim 5 or claim 6, wherein the circuit film further comprises a plurality of first signal lines, a plurality of second signal lines, a plurality of third signal lines, and a plurality of fifth signal lines disposed on a first surface of the circuit film,
wherein the circuit film further comprises a plurality of fourth signal lines disposed on a second surface of the circuit film,
wherein the first via holes electrically connect the first signal lines and the fourth signal lines,
wherein at least some of the plurality of first signal lines, at least some of the plurality of fourth signal lines, and at least some of the plurality of first via holes overlap the display area, and
wherein the first direction is perpendicular to a direction in which one of the first signal lines extends.

8. The display device of claim 7, further comprising:
a plurality of third via holes and a plurality of fourth via holes formed through the substrate in the non-display area;
a plurality of first pads disposed on the plurality of third via holes and the substrate; and
a plurality of second pads disposed on the plurality of fourth via holes and the substrate,
wherein at least one of the plurality of first via holes overlaps one of the plurality of first pads; and optionally further comprising:
an integrated circuit mounted on the circuit film,
wherein one of the first signal lines is electrically connected to one of the plurality of third via holes,
wherein one of the fifth signal lines is electrically connected to one of the plurality of fourth via holes,
wherein one of the fifth signal lines is electrically connected to the integrated circuit, and
wherein each of the plurality of third via holes and the plurality of fourth via holes is positioned to be farther from the display area than each of the plurality of first via holes from the display area.

9. The display device of any one of claims 5 to 8, further comprising:
a heat radiation plate disposed below the substrate and configured to overlap at least a part of the display area,
wherein the circuit film is spaced apart from the heat radiation plate.

10. The display device of any one of claims 5 to 9, wherein the entire circuit film overlaps the substrate.

11. The display device of claim 10, wherein the circuit film further comprises:
a plurality of first signal lines, a plurality of second signal lines, and a plurality of third signal lines disposed on a second surface of the circuit film;
a plurality of fourth signal lines and a plurality of fifth signal lines disposed on a first surface of the circuit film; and
a plurality of second via holes configured to electrically connect the second signal lines and the fifth signal lines and formed through the circuit film,
wherein one of the plurality of first via holes electrically connects one of the first signal lines and the one of fourth signal lines,
wherein at least some of the plurality of second via holes overlap the display area, and wherein the first direction is perpendicular to a direction in which one of the first signal lines extends.

12. The display device of claim 11, wherein the first signal line, the second signal line, and the fifth signal line at least partially overlap the display area.

13. The display device of claim 11 or claim 12, further comprising:
a plurality of first pads and a plurality of second pads disposed on the substrate in the non-display area; and
an integrated circuit mounted on the circuit film,
wherein a part of each of one of the first signal lines and one of the second signal lines is electrically connected to the integrated circuit,
wherein one of the fourth signal lines is connected to one of the plurality of second pads,
wherein one of the fifth signal lines is connected to one of the plurality of first pads, and
wherein at least one of the plurality of first via holes overlaps one of the plurality of second pads; and optionally:
wherein at least one of the plurality of first pads is disposed to be closer to the display area than at least one of the plurality of second pads to the display area; and/or
further comprising:
a plurality of third via holes and a plurality of fourth via holes formed through the substrate in the non-display area,
wherein the plurality of first via holes are disposed to be farther from the display area than the plurality of third via holes and the plurality of fourth via holes from the display area.

14. The display device of any preceding claim, wherein an arrangement direction of the plurality of first via holes included in the first group is equal to or different from an arrangement direction of the plurality of first via holes included in the second group; and optionally:
wherein the arrangement direction of the plurality of first via holes included in the first group intersects the arrangement direction of the plurality of first via holes included in the second group at one of the plurality of first via holes included in the first group.

15. The display device of any preceding claim, wherein the circuit film further comprises a plurality of signal lines disposed on at least one of a top surface or rear surface of the circuit film, a first protective layer disposed on the top surface of the circuit film, and a second protective layer disposed on the rear surface of the circuit film, and
wherein the first protective layer comprises an open area exposing at least a portion of the plurality of signal lines disposed on the top surface of the circuit film, or the second protective layer comprises an open area exposing at least a portion of the plurality of signal lines disposed on the rear surface of the circuit film.
